# EUROPÄISCHE PATENTANMELDUNG

(11) **EP 4 640 418 A2**
(43) Veröffentlichungstag der Anmeldung: **29.10.2025**
(21) Anmeldenummer: 25172888.7
(22) Anmeldetag: 16.11.2017
(51) Int. Cl.: B29D 11/00, C23C 14/34, C23C 14/35, C23C 14/50, C23C 14/56, H01J 37/32, H01J 37/34, G02B 1/10

(54) **ANLAGE, VERFAHREN UND TRÄGER ZUR BESCHICHTUNG VON BRILLENGLÄSERN**

(30) Priorität: 14.12.2016 DE 102016014835; 16.12.2016 DE 102016014982; 21.12.2016 DE 102016125273
(62) Teilanmeldung aus: 17808811.8
(71) Anmelder: Schneider GmbH & Co. KG, 35112 Fronhausen (DE)
(72) Erfinder: HEUKEN, Michael, 52078 Aachen (DE); LERCH, Wilfried, 89160 Dornstadt-Tomerdingen (DE)
(74) Vertreter: Von Rohr Patentanwälte Partnerschaft mbB

(57) **Zusammenfassung**

Es werden eine Anlage, ein Träger und ein Verfahren zur Beschichtung von Brillengläsern vorgeschlagen, wobei ein Träger mit rotierbar gehaltenen Brillengläsern nacheinander in verschiedene Beschichtungsvorrichtungen oder Beschichtungslinien gefördert wird, um abwechselnd entgegengesetzte Seiten der Brillengläser zu beschichten und/oder unterschiedliche Beschichtungen aufzubringen. Insbesondere werden die Träger mit den Brillengläsern von einer Beschichtungsvorrichtung oder Beschichtungslinie mittels einer evakuierten Transferkammer zu einer anderen Beschichtungsvorrichtung oder Beschichtungslinie gefördert.

## Beschreibung

Die vorliegende Erfindung betrifft eine Anlage zur Beschichtung von Brillengläsern gemäß dem Oberbegriff des Anspruchs 1, ein Verfahren zur Beschichtung von Brillengläsern gemäß dem Oberbegriff des Anspruchs 9 sowie einen Träger zur Beschichtung von Brillengläsern gemäß dem Oberbegriff des Anspruchs 14.

Die vorliegende Erfindung betrifft das Beschichten von Brillengläsern vorzugsweise durch Gasphasenabscheidung, insbesondere durch Sputtern, welches auch Kathodenzerstäubung genannt wird. Hierbei werden Atome aus einem Festkörper, dem sogenannten Target, durch Auftreffen von energiereichen Ionen herausgelöst und gehen in eine Gasphase über. Insbesondere betrifft die vorliegende Erfindung das sogenannte Magnetronsputtern, bei dem zusätzlich zu einem angelegten elektrischen Feld auch ein Magnetfeld eingesetzt wird.

In der Praxis ist es schwierig, eine gleichmäßige, effiziente und/oder individuelle bzw. angepasste Beschichtung von zu beschichtenden Brillengläsern zu erreichen, auch wenn aus dem Stand der Technik viele verschiedene Vorrichtungen und Verfahren bekannt sind.

Die WO 2013/131656 A2 befasst sich mit einer Anlage und einem Verfahren zum Bearbeiten und Beschichten von Brillengläsern. Die Brillengläser können verschiedenen Vorrichtungen wahlweise zugefördert werden. Auf spezifische Anforderungen für eine effiziente Beschichtung wird nicht näher eingegangen.

Die DE 196 06 463 A1 und die EP 0 953 657 A1 offenbaren Anlagen zum Beschichten von Substraten durch Sputtern, wobei eine zentrale Handhabungseinrichtung in einer Zentralkammer an mehrere Beschichtungsvorrichtungen angeschlossen ist und wobei die Substrate von der Handhabungseinrichtung in die Beschichtungsvorrichtungen gefördert werden. Auf die Belange der Beschichtung von Brillengläsern wird nicht näher eingegangen.

Die DE 44 07 909 C3, die den Ausgangspunkt der vorliegenden Erfindung bildet, offenbart eine Anlage und ein Verfahren zur Beschichtung von Brillengläsern, wobei die Brillengläser auf einen drehbaren Träger gelegt und nacheinander verschiedenen Beschichtungsstationen durch Drehen zugefördert werden. Es wird hier keine optimale Beschichtung der Brillengläser ermöglicht.

Der vorliegenden Erfindung liegt die Aufgabe zugrunde, eine Anlage, ein Verfahren und einen Träger zur Beschichtung von Brillengläsern anzugeben, wobei eine sehr effiziente und/oder individuelle bzw. angepasste Beschichtung und/oder ein einfacher, kompakter und/oder kostengünstiger Aufbau ermöglicht wird bzw. werden.

Die obige Aufgabe wird durch eine Anlage gemäß Anspruch 1, ein Verfahren gemäß Anspruch 9 oder einen Träger gemäß Anspruch 14 gelöst. Vorteilhafte Weiterbildungen sind Gegenstand der Unteransprüche.

Gemäß einem Aspekt der vorliegenden Erfindung zeichnet sich eine vorschlagsgemäße Anlage mit mehreren Beschichtungsvorrichtungen und einer Fördereinrichtung zur Förderung der Brillengläser oder eines Trägers mit den Brillengläsern von einer Beschichtungsvorrichtung zu einer anderen Beschichtungsvorrichtung insbesondere dadurch aus, dass die Anlage eine Transferkammer aufweist und dass die Beschichtungsvorrichtungen separate Beschichtungskammern aufweisen, wobei die Beschichtungskammern und die Transferkammer ein durchgehendes bzw. zusammenhängendes Vakuumsystem bilden. So wird eine sehr gleichmäßige, effiziente und/oder individuelle bzw. angepasste Beschichtung und/oder ein einfacher, kompakter bzw. kostengünstiger Aufbau ermöglicht.

Das bevorzugte Vakuumsystem bzw. die bevorzugte Verkettung aller für die Brillenglasbeschichtung (im Vakuum) notwendigen Prozessschritte in einer Anlage bzw. einem Vakuumsystem führt insbesondere dazu, dass keine Einzelschritte oder Zwischenschritte in der Atmosphäre erfolgen. Hierdurch wird ein besonders effizienter Ablauf ermöglicht, wobei insbesondere aber auch unerwünschte Verschmutzungen oder dergleichen vermieden werden können.

Ein weiterer, auch unabhängig realisierbarer Aspekt der vorliegenden Erfindung ist auf eine Anlage zur Beschichtung von Brillengläsern gerichtet, wobei ein Träger zur Halterung von zwei oder mehr zu beschichteten Brillengläsern nacheinander in verschiedene Beschichtungsvorrichtungen gefördert bzw. von diesen zur Beschichtung aufgenommen wird. Hierzu ist eine Fördereinrichtung vorgesehen, die den Träger von einer Beschichtungsvorrichtung in eine andere Beschichtungsvorrichtung fördert. Die Beschichtungsvorrichtungen weisen separate Beschichtungskammern auf und/oder sind mittels Schleusen voneinander getrennt oder trennbar.

So wird eine sehr gleichmäßige, effiziente und/oder individuelle bzw. angepasste Beschichtung ermöglicht.

Ein anderer, unabhängig realisierbarer Aspekt der vorliegenden Erfindung liegt darin, dass die Brillengläser nacheinander in verschiedenen Beschichtungsvorrichtungen von entgegengesetzten Seiten beschichtet werden. Hierbei wird der Träger entsprechend mit den zu beschichtenden Brillengläsern durch die Beschichtungsvorrichtungen bewegt. So kann wiederum eine sehr gleichmäßige, effiziente und/oder individuelle bzw. angepasste Beschichtung ermöglicht werden.

Ein weiterer, unabhängig realisierbarer Aspekt der vorliegenden Erfindung sieht vor, dass der Träger nacheinander verschiedenen Beschichtungsvorrichtungen zugeführt wird und dort die Brillengläser beschichtet werden, insbesondere wobei die Brillengläser während des Beschichtens um eigene, also separate Achsen rotieren. Auch hierdurch kann wiederum eine sehr gleichmäßige, effiziente und/oder individuelle bzw. angepasste Beschichtung erreicht werden.

Noch ein anderer, unabhängig realisierbarer Aspekt der vorliegenden Erfindung liegt darin, dass die Brillengläser nacheinander in verschiedenen Beschichtungsvorrichtungen beschichtet werden, wobei der Träger mit den zu beschichtenden Brillengläsern von einer Beschichtungsvorrichtung zu einer anderen Beschichtungsvorrichtung unter Unterdruck bzw. durch eine evakuierte oder evakuierbare Transferkammer gefördert wird. Hierdurch kann ein unerwünschtes bzw. übermäßiges Belüften der verschiedenen Beschichtungsvorrichtungen vermieden oder zumindest minimiert und dadurch ein besonders effizientes Beschichten erreicht werden.

Gemäß einem anderen, unabhängig realisierbaren Aspekt der vorliegenden Erfindung werden die Brillengläser zunächst mit einer ersten - insbesondere funktionellen - Beschichtung oder Grundbeschichtung und anschließend mit mindestens einer weiteren Beschichtung - vorzugsweise mindestens einer dielektrischen Schicht oder mehreren unterschiedlichen Schichten, insbesondere zur Erzeugung eines Antireflex-Schichtpakets bzw. zur Entspiegelung und/oder zur Erzeugung einer Verspiegelung - in einer anderen Beschichtungsvorrichtung oder Beschichtungslinie versehen, insbesondere wobei die Brillengläser jeweils in Gruppen von zwei oder vier Brillengläsern beschichtet werden und/oder wobei die Brillengläser unter Unterdruck von der ersten Beschichtungsvorrichtung bzw. Beschichtungslinie zu der anderen Beschichtungsvorrichtung bzw. Beschichtungslinie gefördert werden. So kann wiederum eine sehr gleichmäßige, effiziente und/oder individuelle bzw. angepasste Beschichtung realisiert werden.

Ein vorschlagsgemäßes Verfahren und eine vorschlagsgemäße Anlage zeichnen sich besonders bevorzugt dadurch aus, dass die Beschichtungsvorrichtung oder Beschichtungslinie für eine Beschichtung, insbesondere die weitere Beschichtung, aus einer Mehrzahl von Beschichtungsvorrichtungen bzw. Beschichtungslinien insbesondere in Abhängigkeit von der Verfügbarkeit, technischen Ausstattung und/oder vorhandenen Ressourcen auswählbar ist oder ausgewählt wird.

Insbesondere wird durch das vorschlagsgemäße Verfahren und die vorschlagsgemäße Anlage eine individuelle bzw. angepasste Beschichtung von Brillengläsern bei hohem Durchsatz und/oder in einem zusammenhängenden Vakuumsystem ermöglicht. Insbesondere wird nämlich in Abhängigkeit von der Größe und/oder Form der Brillengläser, insbesondere in Abhängigkeit von einer konvexen oder konkaven Krümmung der Krümmung der zu beschichtenden Oberfläche(n) und/oder in Abhängigkeit von der zu beschichtenden Oberfläche(n), das Beschichten in einer entsprechend ausgewählten Beschichtungsvorrichtung bzw. -linie und/oder durch entsprechende Anpassung der Beschichtungsparameter ermöglicht. So wird ein sehr spezifisches und damit optimiertes Beschichten der Brillengläser ermöglicht.

Gemäß einem weiteren, unabhängig realisierbaren Aspekt der vorliegenden Erfindung erfolgt das Beschichten bzw. Sputtern der beiden entgegengesetzten Seiten von Brillengläsern, insbesondere sowohl von konvexen als auch konkaven Oberflächen oder Seiten eines Brillenglases, vorzugsweise zeitgleich oder nacheinander jeweils mit einem Paar von Sputterquellen bzw. Targets. Hierdurch wird das Erzeugen von besonders gleichmäßigen Beschichtungen ermöglicht oder erleichtert.

Gemäß einem anderen, auch unabhängig realisierbaren Aspekt der vorliegenden Erfindung wird der Abstand der Sputterquellen, insbesondere der Targets bzw. Kathoden, die insbesondere in einer Beschichtungsvorrichtung zum Beschichten von Brillengläsern eingesetzt werden, als Einstellparameter verwendet oder variiert, vorzugsweise um eine besonders gleichmäßige Beschichtung zu erzielen.

Gemäß einem weiteren, unabhängig realisierbaren Aspekt der vorliegenden Erfindung wird ein Träger zur Beschichtung von Brillengläsern vorzugsweise mittels Gasphasenabscheidung, insbesondere Sputtern, vorgeschlagen, insbesondere wobei die Brillengläser von entgegengesetzten Seiten zur beidseitigen Beschichtung zugänglich und um eigene Achsen rotierbar sind. So wird eine gleichmäßige, effiziente und/oder individuelle bzw. angepasste Beschichtung ermöglicht.

Gemäß einem anderen, unabhängig realisierbaren Aspekt wird der Träger mit einer Zahnstange oder einem Wagen bzw. Gestell zur Förderung in bzw. durch eine Beschichtungsvorrichtung gekoppelt. Dies gestattet insbesondere einen einfachen und/oder kostengünstigen Aufbau.

Generell gilt für die vorgenannten Aspekte vorzugsweise folgendes:
Vorzugsweise erfolgt das Beschichten zumindest teilweise durch Gasabscheidung, also im Vakuum, und insbesondere durch Sputtern, besonders bevorzugt Magnetronsputtern.

Besonders bevorzugt werden die Brillengläser in Gruppen von bis zu zehn Brillengläsern, insbesondere zwei oder vier Brillengläsern beschichtet.

Besonders bevorzugt werden die Brillengläser in verschiedenen Beschichtungsvorrichtungen nacheinander von entgegengesetzten Seiten beschichtet.

Besonders bevorzugt wird der Träger zusammen mit den zu beschichtenden Brillengläsern unter Unterdruck bzw. mittels einer evakuierten Transferkammer von einer Beschichtungsvorrichtung oder -linie zu einer anderen Beschichtungsvorrichtung oder -linie gefördert.

Besonders bevorzugt wird der Träger mit den zu beschichtenden Brillengläsern und insbesondere auch zusammen mit dem Wagen bzw. Gestell und/oder der Zahnstange von der jeweiligen Beschichtungsvorrichtung zur Beschichtung vollständig aufgenommen.

Vorzugsweise wird eine vorbestimmte bzw. definierte, insbesondere zumindest im Wesentlichen vertikale Ausrichtung des Trägers und/oder der Linsen in den Beschichtungsvorrichtungen und/oder in der Anlage bzw. beim Bewegen durch die Beschichtungsvorrichtungen und/oder Anlage beibehalten. Dies ist einem kompakten Aufbau insbesondere mit geringem Platzbedarf und/oder einem einfachen Handling zuträglich.

Vorzugsweise wird ein durchgängiges bzw. zusammenhängendes Vakuumsystem gebildet, das insbesondere mehrere Beschichtungsvorrichtungen bzw. Beschichtungskammern, Schleusen und mindestens eine Transferkammer sowie ggf. eine oder mehrere Aufnahmestationen und/oder Abgabestationen umfasst.

Insbesondere werden verschiedene Prozesskammern bzw. Beschichtungsvorrichtungen mit ggf. verschiedenen Beschichtungstechnologien zu einem einzigen, verketten System, insbesondere zusammenhängenden Vakuumsystem, kombiniert.

Besonders bevorzugt werden gemäß einem weiteren, auch unabhängig realisierbaren Aspekt der vorliegenden Erfindung verschiedene Beschichtungstechnologien in einer vorschlagsgemäßen Anlage und/oder in einem vorschlagsgemäßen Verfahren miteinander kombiniert, insbesondere verschiedene Gasphasenabscheideverfahren, wie Sputtern, Magnetronsputtern, thermisches Verdampfen, CVD-Beschichten und/oder PVD-Beschichten oder dergleichen.

Besonders bevorzugt ist die Anlage modular aufgebaut, so dass in Abhängigkeit von längeren und kürzeren Beschichtungsprozessen mehr oder weniger Module bzw. Einheiten oder Vorrichtungen für die jeweiligen Beschichtungen miteinander kombiniert bzw. zu einem zusammenhängenden Vakuumkammersystem kombiniert werden.

Besonders bevorzug werden für lange Prozesse eigene bzw. separate Beschichtungskammern eingesetzt, wohingegen die gleiche Beschichtungskammer für mehrere kurze Prozesse hintereinander mehrfach benutzt werden kann, so dass insgesamt ein optimaler Durchsatz erreichbar ist.

Besonders bevorzugt ermöglichen die vorschlagsgemäße Anlage und das vorschlagsgemäße Verfahren eine komplette Beschichtung eines Brillenglases bzw. einer Brillenglasseite, so dass insbesondere integriert alle erforderlichen Beschichtungen und nachträglichen Oberflächenbehandlungen vorzugsweise in einer Anlage vorgenommen werden können.

Vorschlagsgemäß können insbesondere Beschichtungen zur Entspiegelung und/oder Verspiegelung aufgebracht werden.

Vorschlagsgemäß können unterschiedliche Oberflächeneigenschaften durch entsprechende Behandlung oder Beschichtung - auch Oberflächenfinish oder Endbeschichtung genannt - erreicht werden, also besonders bevorzugt oleophobe Eigenschaften oder Oberflächen, hydrophobe Eigenschaften oder Oberflächen und/oder sogenannte Antifog-Oberflächen, die wenig beschlagen. Hierzu wird insbesondere mindestens eine zusätzliche Beschichtungsvorrichtung für das Oberflächenfinish bzw. die Endbeschichtung oder Behandlung eingesetzt und insbesondere in das Vakuumsystem bzw. die Anlage integriert.

Vorschlagsgemäß erfolgt insbesondere keine durchlaufende Behandlung oder Beschichtung der Brillengläser, sondern eine Aufteilung in unterschiedliche Beschichtungsprozesse und/oder auf unterschiedliche Beschichtungsvorrichtungen und/oder Beschichtungslinien, wodurch eine hohe Flexibilität bei hohem Durchsatz ermöglicht wird.

Vorschlagsgemäß wird insbesondere ein automatisiertes Beschichten von Brillengläsern, besonders bevorzugt nacheinander in verschiedenen Beschichtungsvorrichtungen, ermöglicht, wobei insbesondere ein automatisierter und/oder optimierter Betrieb und Durchlaufen der verschiedenen Beschichtungsvorrichtungen ermöglicht wird.

Insbesondere werden die Brillengläser in einem Batch-Betrieb, also nicht in einem Durchlaufverfahren bzw. nicht kontinuierlich, beschichtet, wobei das Beschichten insbesondere nur in kleinen Gruppen von Brillengläsern, vorzugsweise in Gruppen von einzelnen Paaren oder mehreren Paaren von Brillengläsern, bedarfsweise aber auch von einzelnen Brillengläsern oder beliebigen Anzahlen von Brillengläsern, besonders bevorzugt von bis zu oder weniger als zehn Brillengläsern, erfolgt.

Wie bereits genannt, bezieht sich die vorliegende Erfindung insbesondere auf das Beschichten von nicht flachen bzw. von gekrümmten Linsen oder Gläsern, insbesondere Brillengläsern. Optional kann die vorliegende Erfindung jedoch auch für sonstige Linsen bzw. optischen Bauteile eingesetzt werden.

Die vorgenannten Aspekte sowie die sich aus der weiteren Beschreibung ergebenden Merkmale und Aspekte der vorliegenden Erfindung können unabhängig voneinander, aber auch in beliebiger Kombination realisiert werden.

Weitere Aspekte, Vorteile und Merkmale der vorliegenden Erfindung ergeben sich aus den Ansprüchen und der folgenden Beschreibung bevorzugter Ausführungsformen anhand der Zeichnung. Es zeigt:
- Fig. 1: einen schematischen Schnitt einer Beschichtungsvorrichtung zur Beschichtung von Brillengläsern;
- Fig. 2: eine schematische Seitenansicht der Beschichtungsvorrichtung;
- Fig. 3: eine schematische Seitenansicht der Beschichtungsvorrichtung entsprechend Fig. 2, jedoch mit alternativ angeordneten Brillengläsern;
- Fig. 4: eine schematische Seitenansicht eines Ausschnitts einer vorschlagsgemäßen Anlage und eines vorschlagsgemäßen Trägers zur Halterung von zu beschichtenden Brillengläsern;
- Fig. 5: eine andere Seitenansicht des Trägers von Fig. 4;
- Fig. 6: eine schematische Draufsicht der vorschlagsgemäßen Anlage mit mehreren Beschichtungsvorrichtungen gemäß einer ersten Ausführungsform; und
- Fig. 7: eine schematische Draufsicht der vorschlagsgemäßen Anlage gemäß einer zweiten Ausführungsform.

In den Figuren werden für gleiche Komponenten und Bauteile die gleichen Bezugszeichen verwendet, auch wenn eine wiederholte Beschreibung weggelassen ist.

Zunächst wird ein besonders bevorzugter Aufbau und eine besonders bevorzugte Arbeitsweise einer Beschichtungsvorrichtung erläutert, bevor auf einen vorschlagsgemäßen Träger und auf eine vorschlagsgemäße Anlage und vorschlagsgemäße Verfahren zur Beschichtung näher eingegangen wird.

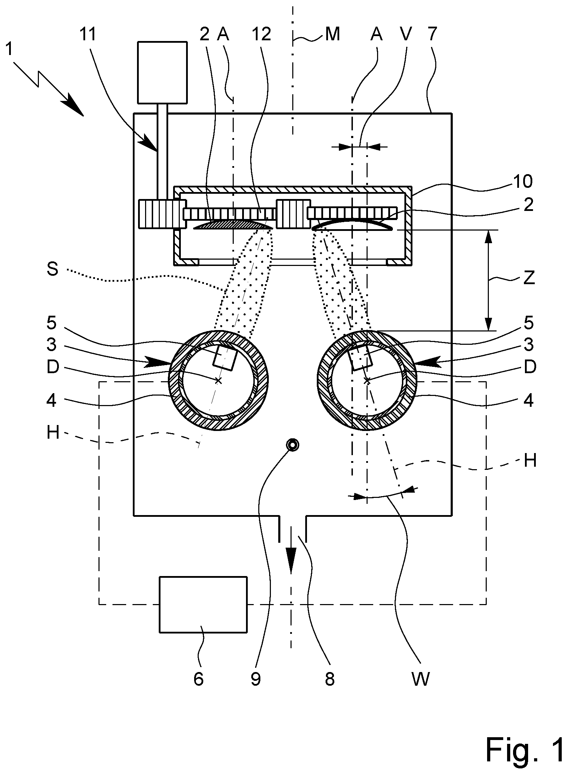

Fig. 1 zeigt in einem sehr schematischen Schnitt eine Beschichtungsvorrichtung 1 zur Beschichtung von Brillengläsern 2. Nachfolgend werden diese auch nur als Linsen bezeichnet. Insbesondere erfolgt das Beschichten nämlich vor einer Randbearbeitung zur Anpassung an ein Brillengestell oder dergleichen.

Die Linsen bzw. Brillengläser 2 sind beim Beschichten insbesondere noch kreisscheibenförmig und/oder weisen vorzugsweise einen definierten oder einheitlichen Durchmesser auf. Jedoch können die Linsen bzw. Brillengläser 2 auch eine andere Form für das Beschichten aufweisen, beispielsweise in der Draufsicht eine elliptische oder sonstige, gegebenenfalls sogar schon eine an eine Brillenfassung angepasste Form oder Kontur aufweisen.

Die Linsen 2 bzw. unbeschichteten Brillenglasrohlinge sind vorzugsweise aus Kunststoff oder Glas hergestellt.

Nachfolgend wird zunächst ein besonders bevorzugter Aufbau der Beschichtungsvorrichtung 1 näher erläutert. Jedoch können grundsätzlich auch anders aufgebaute Beschichtungsvorrichtungen 1 zusätzlich oder alternativ erfindungsgemäß eingesetzt werden, worauf später noch eingegangen wird.

Die Beschichtungsvorrichtung 1 ist vorzugsweise zum Beschichten der Linsen 2 durch Gasphasenabscheidung, insbesondere durch Sputtern, auch Kathodenzerstäubung genannt, also insbesondere im Vakuum ausgebildet. Besonders bevorzugt erfolgt ein sogenanntes Magnetronsputtern. Zusätzlich zu einem elektrisch angelegten Feld wird hierbei auch ein Magnetfeld benutzt bzw. angelegt, worauf später noch etwas näher eingegangen wird.

Besonders bevorzugt werden gekrümmte, insbesondere konkave Oberflächen der Linsen 2 erfindungsgemäß beschichtet. In Fig. 1 ist schematisch bei der auf der rechten Seite dargestellten Linse 2 eine solche gekrümmte Oberfläche angedeutet. Jedoch können grundsätzlich auch konvexe Oberflächen oder sonstige Oberflächen der Linsen 2 entsprechend beschichtet werden.

Die Beschichtungsvorrichtung 1 weist vorzugsweise mindestens eine Sputterquelle 3, hier vorzugsweise zwei Sputterquellen 3, auf.

Die Beschichtungsvorrichtung 1 bzw. die jeweilige Sputterquelle 3 weist ein Target 4 auf, dessen Material beim Beschichten bzw. Sputtern abgetragen wird und - insbesondere zusammen mit anderen Bestandteilen der Gasatmosphäre - die gewünschte Beschichtung auf der jeweiligen Linse 2 bzw. deren zu beschichtenden Oberfläche bildet.

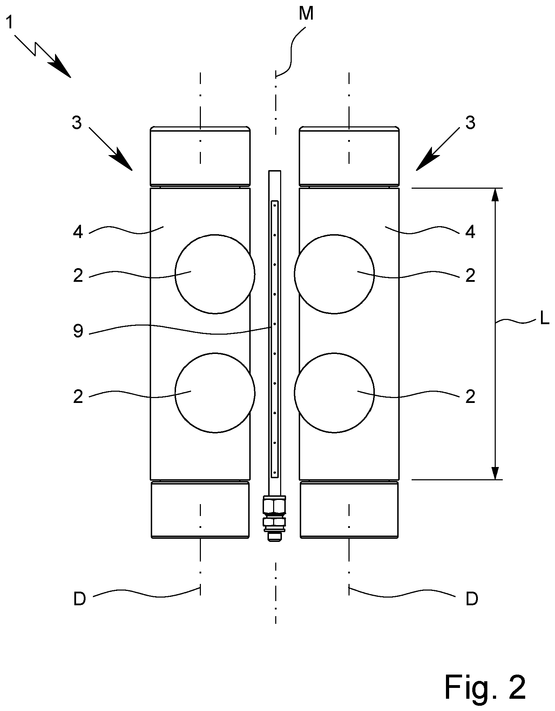

Fig. 2 zeigt die Beschichtungsvorrichtung 1 bzw. Sputterquellen 3 in einer schematischen Seitenansicht.

Die Sputterquellen 3 bzw. Targets 4 sind beim Darstellungsbeispiel bevorzugt zumindest im Wesentlichen länglich bzw. rohrförmig oder zylindrisch ausgebildet.

Die Targets 4 sind insbesondere hohlzylindrisch bzw. rohrförmig ausgebildet.

Die Sputterquellen 3 bzw. Targets 4 sind vorzugsweise parallel zueinander angeordnet.

Vorzugsweise sind die Targets 4 drehbar bzw. rotierbar um Drehachsen D. Die Drehachsen D verlaufen vorzugsweise in einer gemeinsamen Ebene und/oder insbesondere parallel zueinander, wie in den Fig. 1 und 2 angedeutet, können alternativ aber auch zueinander geneigt sein. Die Drehachsen D entsprechen vorzugsweise den Längsachsen der Sputterquellen 3.

Jede Sputterquelle 3 weist vorzugsweise eine Magnetanordnung 5 auf, die dem jeweiligen Target 4 zur Erzeugung des bereits genannten Magnetfelds und damit einer gerichteten Sputterwolke S zugeordnet ist, wie in Fig. 1 schematisch angedeutet. Insbesondere ist die Magnetanordnung 5 unter bzw. in dem jeweiligen Target 4 angeordnet.

Die Beschichtungsvorrichtung 1 weist eine Spannungsquelle 6 auf, wie in Fig. 1 angedeutet, um die Sputterquellen 3 bzw. Targets 4 - insbesondere abwechselnd - als Kathode betreiben bzw. zum Sputtern mit der erforderlichen Spannung, insbesondere in Form von Pulsen, beaufschlagen zu können.

Besonders bevorzugt werden die Sputterquellen 3 bzw. Targets 4 abwechselnd mit Gleichstrom (Pulsen) betrieben bzw. beaufschlagt. Dies wird auch als "Bi-polar DC" bezeichnet. Abwechselnd dient dann eine Sputterquelle 3 bzw. ein Target 4 als Kathode und die andere Sputterquelle 3 bzw. das andere Target 4 als Anode.

Alternativ kann ein Betrieb mit Wechselstrom oder ein sonstiger Betrieb erfolgen.

Alternativ oder zusätzlich können auch eine oder mehrere zusätzliche oder separate Anoden eingesetzt werden, auch wenn dies nicht bevorzugt ist.

Die Beschichtungsvorrichtung 1 weist vorzugsweise eine Beschichtungskammer 7 auf, in der die Beschichtung erfolgt bzw. die Sputterquellen 3 angeordnet sind.

Die Beschichtungskammer 7 ist insbesondere mittels einer in Fig. 1 nur schematisch angedeuteten Einrichtung 8, wie einem Anschluss, einer Vakuumpumpe o. dgl., in gewünschter Weise evakuierbar. Die Einrichtung bzw. Vakuumpumpe 8 ist besonders bevorzugt auf der den Linsen 2 abgewandten Seite der Sputterquellen 3 bzw. Targets 4 und/oder besonders bevorzugt in einer Mittelebene M bzw. mittig angeordnet.

Die Beschichtungsvorrichtung 1 bzw. Beschichtungskammer 7 weist vorzugsweise eine schematisch angedeutete Gaszuführung 9, insbesondere in Form einer sich in den Beschichtungsraum erstreckenden Gaslanze, auf.

Die Beschichtungsvorrichtung 1 weist vorzugsweise einen Träger 10 zur Halterung der Linsen 2 auf, wie in Fig. 1 angedeutet.

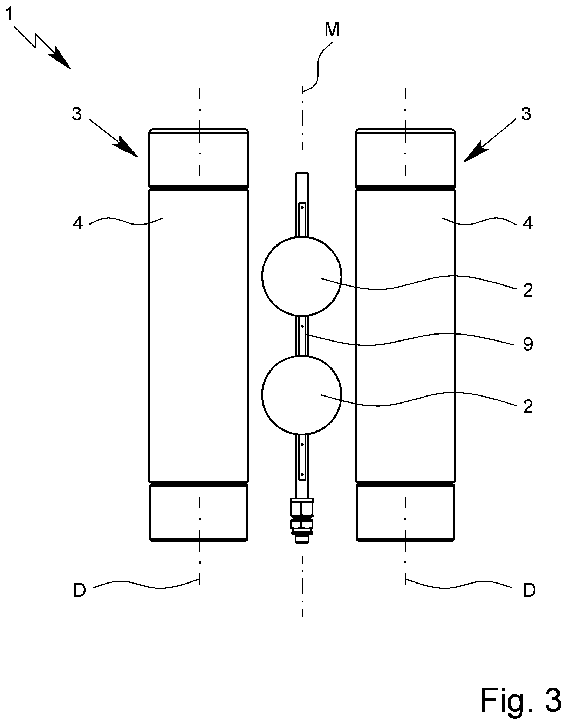

In Fig. 2 und 3 ist der Träger 10 aus Veranschaulichungsgründen nicht dargestellt.

Die zu beschichtenden Linsen 2 sind vorzugsweise jeweils um eine Achse A drehbar bzw. rotierbar. Die Beschichtungsvorrichtung 1 bzw. der Träger 10 ist zur entsprechenden drehbaren Halterung und insbesondere zum entsprechenden Antreiben der Linsen 2 ausgebildet. Insbesondere weist die Beschichtungsvorrichtung 1 einen entsprechenden, in Fig. 1 nur schematisch angedeuteten Drehantrieb 11 auf, vorzugsweise um alle Linsen 2 des Trägers 10 gemeinsam anzutreiben.

Der Träger 10 ist vorzugsweise zusammen mit mindestens zwei Linsen 2 bzw. allen Linsen 2 bzw. hier vier Linsen 2, die gleichzeitig in der Beschichtungsvorrichtung 1 bzw. Beschichtungskammer 7 beschichtet werden, wechselbar.

Insbesondere hält der Träger 10 die Linsen 2 - insbesondere um eigene bzw. unterschiedliche Achsen A - drehbar, besonders bevorzugt drehbar gekoppelt. Besonders bevorzugt weist der Träger 10 eine Drehkopplung 12, beispielsweise über ein entsprechendes Getriebe, auf, wie in Fig. 1 schematisch angedeutet.

Vorzugsweise wird der Träger 10 selbst während der Beschichtung nicht bewegt, sondern nur die davon gehaltenen Linsen 2 rotiert.

Vorzugsweise ist der Träger 10 beim Einsetzen oder Einschieben in die Beschichtungsvorrichtung 1 bzw. Beschichtungskammer 7 automatisch antriebsmäßig oder getriebemäßig, insbesondere mit dem Drehantrieb 11 o. dgl. der Beschichtungsvorrichtung 1 koppelbar.

Besonders bevorzugt hält der Träger die Linsen 2 oder zumindest deren Schwerpunkte bzw. Mittelpunkte zumindest im Wesentlichen in einer Ebene, die besonders bevorzugt parallel zu der gemeinsamen Ebene der Drehachsen D der Targets 4 verläuft.

Der Träger 10 gestattet eine schnelle Beschickung der Beschichtungsvorrichtung 1 bzw. Beschichtungskammer 7 mit den zu beschichtenden Linsen 2 bzw. eine schnelle Entnahme der beschichteten Linsen 2.

Die Beschichtungskammer 7 ist zum Beschichten vorzugsweise gasdicht verschließbar.

Die Beschichtungsvorrichtung 1 bzw. Beschichtungskammer 7 ist vorzugsweise über eine nicht dargestellte Zugangsöffnung mit den zu beschichtenden Linsen 2 bzw. dem Träger 10 beschickbar. Die Zugangsöffnung ist vorzugsweise mittels des Trägers 10 oder durch einen nicht dargestellten Verschluss insbesondere gasdicht verschließbar.

Der Träger 10 ist vorzugsweise generell bei Vorrichtungen zur Beschichtung von Linsen 2 einsetzbar, insbesondere also auch bei anderen Beschichtungsverfahren als dem Sputtern.

Die Drehachsen D bzw. Längserstreckungen L der Targets 4 verlaufen vorzugsweise in einer gemeinsamen Ebene, besonders bevorzugt einer Vertikal- oder Horizontalebene.

Die Linsen 2 sind vorzugsweise oberhalb und/oder (nur) auf einer Seite der vorgenannten Ebene angeordnet.

Vorzugsweise ist jede Linse 2 über einem zugeordneten Target 4 angeordnet. Der Begriff "über" kann sich auf die vertikale Höhe bzw. dem Abstand gegenüber dem zugeordneten Target 4 und/oder darauf beziehen, dass die zu beschichtende Oberfläche der Linse 2 wenigstens eine Flächennormale aufweist, die das Target 4 und besonders bevorzugt deren Drehachse D schneidet.

Vorzugsweise sind die Linsen 2 paarweise einer Sputterquelle 3 bzw. einem Target 4 zugeordnet.

Insbesondere sind jeweils zwei Linsen 2 über einem gemeinsamen Target 4 angeordnet, wie in Fig. 2 angedeutet.

Besonders bevorzugt ist die Beschichtungsvorrichtung 1 bzw. der Träger 10 zur Aufnahme von zwei Paaren von Linsen 2, also von insgesamt vier Linsen 2, ausgebildet, wobei jeweils zwei Linsen 2 einer gemeinsamen Sputterquelle 3 bzw. einem gemeinsamen Target 4 zugeordnet sind.

Die Achse A, um die die Linse 2 bei der Beschichtung jeweils rotiert, ist vorzugsweise relativ zu dem Target 4 bzw. der Sputterquelle 3 oder Drehachse D stationär bzw. fest.

Insbesondere wird eine lineare Bewegung bzw. eine Schwerpunktbewegung, wie eine Kreisbewegung, zwischen der Sputterquelle 3 bzw. des Targets 4 bzw. den Drehachsen D einerseits und der zu beschichtenden Linse 2 bzw. Linsen 2 bzw. Achsen A andererseits vermieden bzw. ausgeschlossen. Dies ist einem besonders einfachen Aufbau zuträglich.

Der (vertikale) Abstand Z der Linse 2 vom zugeordneten Target 4 ist in Fig. 1 und vorzugsweise fest. Optional erfolgt eine Anpassung oder Verstellung des Abstands Z der Linse 2 vom zugeordneten Target 4 in Abhängigkeit von dem Durchmesser und/oder der Krümmung bzw. Form der zu beschichtenden Linse 2 bzw. Oberfläche.

Die Achsen A von zwei einem gemeinsamen Target 4 zugeordneten Linsen 2 verlaufen vorzugsweise in einer gemeinsamen Ebene und insbesondere parallel zueinander.

Die Achsen A verlaufen vorzugsweise quer oder senkrecht zu der Targetebene bzw. gemeinsamen Ebene der Drehachsen D bzw. zu der Drehachse D des zugeordneten Targets 4.

Die Achsen A können in ihrer gemeinsamen Ebene auch relativ zueinander, insbesondere aufeinander zu oder nach außen bzw. voneinander weg geneigt sein.

Die Rotationsachse A der Linse 2 kann auch in in einer Richtung quer zur Drehachse D in horizontaler Richtung bzw. zur Mitte zwischen den beiden Drehachsen D der Targets 4 hin verschoben sein, insbesondere so dass sich ein Versatz oder Abstand V zwischen der Linsenachse A und der zugeordneten Targetachse D bildet, wie in Fig. 1 für die auf der rechten Seite angeordnete Linse 2 angedeutet (gleiches gilt vorzugsweise natürlich auch für die auf der linken Seite angeordnete Linse 2).

Der Abstand V ist vorzugsweise fest. Optional erfolgt eine Anpassung oder Verstellung des Abstands V zwischen der Linsenachse A und der zugeordneten Targetachse D in Abhängigkeit von dem Durchmesser und/oder der Krümmung bzw. Form der zu beschichtenden Linse 2 bzw. Oberfläche.

Die Gaszuführung 9 ist vorzugsweise unterhalb der Sputterquellen 3 bzw. Targets 4 und/oder dazwischen, besonders bevorzugt in der Mittelebene M der Beschichtungsvorrichtung 1 bzw. Beschichtungskammer 7 angeordnet.

Die Gaszuführung 9 ist vorzugsweise rohrförmig und/oder stabartig ausgebildet und/oder mit vorzugsweise in einer Reihe angeordneten und/oder nach oben weisenden Gasauslässen versehen.

Die beim Beschichten auftretende Sputterwolke S, also das zerstäubte Targetmaterial, wird mittels des bereits genannten Magnetfelds bzw. der Magnetanordnung 5 jeweils zumindest im Wesentlichen in eine gewünschte Richtung gelenkt. Diese in Fig. 1 gestrichelt angedeutete Hauptrichtung H der Ausbreitung der Sputterwolke S ist durch entsprechende Anordnung bzw. Ausrichtung der Magnetanordnung 5 beeinflussbar, insbesondere festlegbar.

Beim Darstellungsbeispiel ist die Hauptrichtung H in der Schnittebene senkrecht zu den Drehachsen D und/oder der beiden Targets 4 vorzugsweise zueinander und/oder um den Winkel W (ausgehend von einer parallelen Ausrichtung) geneigt. Vorzugsweise ist der Winkel W einstellbar bzw. anpassbar, insbesondere durch entsprechende Verstellung oder Ansteuerung der Magnetanordnungen 5.

Wie bereits angesprochen, können die Hauptrichtungen H der beiden Sputterwolken S auch parallel zueinander und/oder senkrecht zu der Erstreckungsebene der Targets 4 bzw. Ebene mit dem Drehachsen D verlaufen.

Vorzugsweise verlaufen die Hauptrichtungen H vertikal nach oben oder enthalten eine solche Richtungskomponente. Alternativ kommt eine horizontale Ausrichtung der Hauptrichtungen H vor. Die Anordnung der Linsen 2 und Sputterquellen 3 bzw. Targets 4 muss dann natürlich entsprechend gewählt werden.

Besonders bevorzugt werden die Linsen 2 jeweils paarweise beschichtet, insbesondere werden jeweils gleichzeitig zwei Paare von Linsen 2 beschichtet. Grundsätzlich ist jedoch auch möglich, nur ein Paar von Linsen 2 in der Beschichtungsvorrichtung 1 vorschlagsgemäß zu beschichten. Hierzu werden die beiden Linsen dann vorzugsweise über einen gemeinsamen Taget 4 und/oder zwischen den beiden Targets 4, wie schematisch in Fig. 3 in einer alternativen Anordnung gezeigt, angeordnet.

Insbesondere werden die Linsen 2 in einem Batch-Betrieb, also nicht in einem Durchlaufverfahren bzw. nicht kontinuierlich, beschichtet. Das Beschichten erfolgt insbesondere nur in kleinen Gruppen von Linsen 2, vorzugsweise in Gruppen von einzelnen Paaren oder mehreren Paaren von Linsen 2, bedarfsweise aber auch von einzelnen Linsen 2 oder beliebigen Anzahlen von Linsen 2.

Die Linsen 2 rotieren vorzugsweise zentrisch um die jeweilige Achse A, insbesondere bezüglich der geometrischen Mitte der Linse 2.

Gemäß einer nicht dargestellten Ausführungsvariante können die Linsen 2 optional auch exzentrisch bezüglich der Rotationsachse A rotieren bzw. eingespannt sein. Die Exzentrität ist dabei vorzugsweise kleiner als der Radius der Linse 2, kann ggf. auch größer sein.

Insbesondere schneidet die Rotationsachse A also die jeweilige Linse 2.

Die Achse A verläuft vorzugsweise senkrecht zur Hauptebene der jeweiligen Linse 2.

Jede der Linsen 2 ist vorzugsweise um eine eigene Achse A rotierbar. Die Linsen 2 sind also um verschiedene Achsen A rotierbar.

Die Achse A verläuft vorzugsweise quer, optional senkrecht, zu der Längserstreckung bzw. Drehachse D des zugeordneten Targets 4.

Insbesondere schneidet die Rotationsachse A der jeweiligen Linse 2 das zugeordnete Target 4, wie in Fig. 1 angedeutet, oder optional die Längs- bzw. Drehachse D des zugeordneten Targets 4.

Die Linse 2 weist während des Beschichtens bzw. Rotierens mit ihrer zu beschichtenden Seite vorzugsweise immer zu dem zugeordneten Target 4 bzw. den beiden zugeordneten Targets 4.

Vorzugsweise verläuft die Drehachse D des jeweiligen Targets 4 senkrecht zu einer beliebigen bzw. mindestens einer Flächennormalen der zu beschichtenden Linse 2 bzw. Oberfläche.

Die Flächennormale des optischen oder geometrischen Zentrums der Linse 2 kann zur Rotationsachse A bzw. Drehachse D geneigt sein.

Die Linsenzentren sind vorzugsweise symmetrisch zum jeweiligen Target 4 in Längserstreckung des Targets 4 angeordnet.

Die zu beschichtenden Linsen 2 bzw. deren geometrische oder optische Zentren sind vorzugsweise zumindest im Wesentlichen in einer gemeinsamen Ebene angeordnet, wobei diese Ebene besonders bevorzugt parallel zu der Erstreckungsebene der Sputterquellen 3 bzw. Targets 4 bzw. Drehachsen D verläuft.

Besonders bevorzugt werden der Kathodenabstand, also der Abstand der Targets 4 zueinander und/oder der Abstand Z der Linsen 2 von den Targets 4 bzw. Sputterquellen 3 und/oder die Winkel W in Abhängigkeit von den zu beschichtenden Linsen 2, insbesondere von der Oberflächenform der zu beschichtenden Linsen 2, also beispielsweise flachgekrümmt oder stark gekrümmt bzw. in Abhängigkeit vom Maß der Krümmung und/oder ob es sich um eine konkave oder konvexe Oberfläche handelt variiert.

Nachfolgend wird zunächst ein besonders bevorzugter Aufbau des vorschlagsgemäßen Trägers 10 näher erläutert. Die bisherigen Ausführungen und Erläuterungen, insbesondere bzgl. Fig. 1 gelten vorzugsweise entsprechend oder ergänzend, auch ohne explizite Wiederholung.

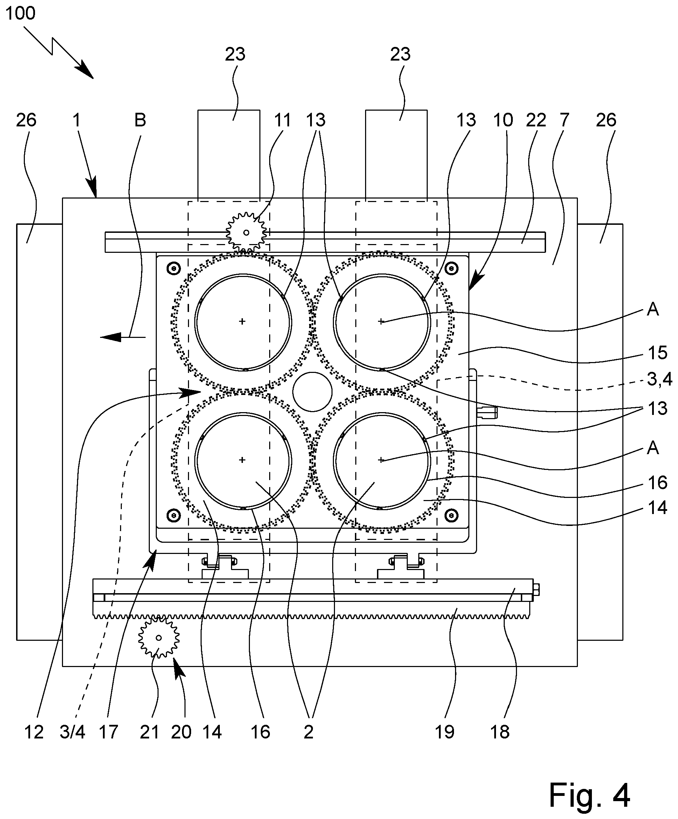

Fig. 4 zeigt in einer schematischen Seitenansicht einen Ausschnitt einer vorschlagsgemäßen Anlage 100 zur Beschichtung von Brillengläsern 2 und eine besonders bevorzugte Ausführung des vorschlagsgemäßen Trägers 10 zur Halterung von zu beschichtenden Linsen bzw. Brillengläsern 2.

In Fig. 4 ist insbesondere eine Beschichtungsvorrichtung 1 der Anlage 100 quasi als Schnitt bzw. in einem geöffneten Zustand dargestellt, so dass der im dargestellten Zustand in der Beschichtungsvorrichtung 1 befindliche Träger 10 zusammen mit davon gehaltenen Linsen 2 sichtbar ist. Die Beschichtungsvorrichtung 1 ist vorzugsweise wie bereits beschrieben aufgebaut und/oder arbeitet vorzugsweise wie bereits beschrieben.

Die Linsen 2, hier insbesondere ein oder zwei Paare von Linsen 2, werden vorzugsweise randseitig oder umfangseitig und/oder federnd, insbesondere von vorzugsweise federnden bzw. nachgiebigen Halteelementen 13 gehalten.

Die Halteelemente 13 sind insbesondere in radialer Richtung zur Mitte bzw. Linse 2 hin vorgespannt. Die Halteelemente 13 halten die entsprechende Linse 2 insbesondere zentrisch in oder unter jeweils einer Öffnung 16 des Trägers 10, so dass die Linse 2 in gewünschter Weise beschichtet werden kann.

Besonders bevorzugt ist die Anlage 100 bzw. der Träger 10 derart ausgebildet, dass die von dem Träger 10 gehaltenen Linsen 2 von entgegengesetzten Seiten bzw. beidseitig - insbesondere ohne Lösen vom Träger 10 - beschichtet werden können. Vorzugsweise ist der Träger 10 auf beiden Seiten, insbesondere Flachseiten, entsprechend offen bzw. mit Öffnungen 16 versehen, um die beidseitige Beschichtung der Linsen 2 zu ermöglichen.

Die Halteelemente 13 sind beim Darstellungsbeispiel vorzugsweise mit einem Halter bzw. Lagerelement, hier einem Ringelement 14 gekoppelt. Vorzugsweise ist das Lager- bzw. Ringelement 14 drehbar bzw. drehend antreibbar. Beim Darstellungsbeispiel ist das Lager- bzw. Ringelement 14 insbesondere als Zahnrad ausgeführt oder mit einem Zahnrad gekoppelt, so dass besonders bevorzugt alle - hier vier - Lager- bzw. Ringelemente 14 und die zugeordneten Linsen 2 um eigene Achsen A, also um verschiedene Achsen A rotierbar sind.

Beim Darstellungsbeispiel erfolgt die Drehkopplung 12 insbesondere über den kämmenden Eingriff der Zahnräder bzw. Ringelemente 14. Jedoch sind auch andere konstruktive Lösungen, beispielsweise mit einem Getriebe, Riemen o. dgl., möglich.

Der Träger 10 weist vorzugsweise einen insbesondere plattenförmigen Grundkörper 15 auf, in den die Halterungen bzw. Halteelemente 13 für die Linsen 2 und insbesondere auch die Lager- bzw. Ringelemente 14 integriert sind.

Der Grundkörper 15 ist vorzugsweise beidseitig abgedeckt und/oder mit den bereits genannten Öffnungen 16 versehen, so dass die Linsen 2 entsprechend beschichtet werden können.

Der Träger 10 ist vorzugsweise mit einem Wagen oder Gestell 17 koppelbar oder gekoppelt, wie in Fig. 4 angedeutet. Der Wagen bzw. das Gestell 17 dient insbesondere einer Handhabung bzw. Förderung des Trägers 10 mit den zu beschichtenden Linsen 2 in der Anlage 100 bzw. durch die Beschichtungsvorrichtung(en) 1.

Beim Darstellungsbeispiel ist das Gestell 17 vorzugsweise zur klemmenden und/oder kraftschlüssigen Aufnahme des Trägers 10 ausgebildet und/oder gabelförmig ausgeführt.

Der Träger 10 ist insbesondere über das Gestell 17 vorzugsweise mit einem Führungselement 18 und/oder einer Zahnstange 19 koppelbar oder gekoppelt, wie in Fig. 4 schematisch angedeutet.

Beim Darstellungsbeispiel ist das Führungselement 18 vorzugsweise gelenkig mit dem Gestell 17 gekoppelt, wobei die Gelenkachse insbesondere in der Förderrichtung F verläuft. Jedoch sind auch andere konstruktive Lösungen möglich.

Das Führungselement 18 trägt vorzugsweise die Zahnstange 19.

Beim Darstellungsbeispiel weist die Zahnung der Zahnstange 19 vorzugsweise nach unten. Jedoch sind hier auch andere Ausrichtungen möglich. Beispielsweise kann die Zahnung auch zur Seite oder grundsätzlich auch nach oben weisen.

Die Anlage 100 bzw. die dargestellte oder jede Beschichtungsvorrichtung 1 weist vorzugsweise eine Fördereinrichtung 20 zur Förderung des Trägers 10 durch die Anlage 100 bzw. in die (jeweilige) Beschichtungsvorrichtung 1 und/oder aus dieser auf.

Besonders bevorzugt wird nämlich der Träger 10 zusammen mit den zu beschichtenden Linsen 2 und insbesondere auch zusammen mit dem Wagen bzw. Gestell 17 vollständig in der jeweiligen Beschichtungsvorrichtung 1 bzw. deren Beschichtungskammer 7 zum Beschichten aufgenommen.

Die Fördereinrichtung 20 bzw. vorzugsweise jede Beschichtungsvorrichtung 1 umfasst beim Darstellungsbeispiel vorzugsweise einen Förderantrieb 21, der insbesondere mit einem entsprechenden Ritzel oder dergleichen an dem Träger 10 bzw. Gestell 17, besonders bevorzugt an der Zahnstange 19, zur bedarfsweisen - insbesondere linearen - Förderung oder Bewegung - beispielsweise in die schematisch angedeutete Förderrichtung F - angreift oder angreifen kann. Insbesondere umfasst der Förderantrieb 21 einen Schrittmotor mit dem Ritzel.

Der Träger 10 wird vorzugsweise an Schienen 22 bewegbar bzw. verschiebbar in der Anlage 100 bzw. Beschichtungsvorrichtung 1, vorzugsweise an entgegengesetzten Seiten bzw. oben und/oder unten, geführt.

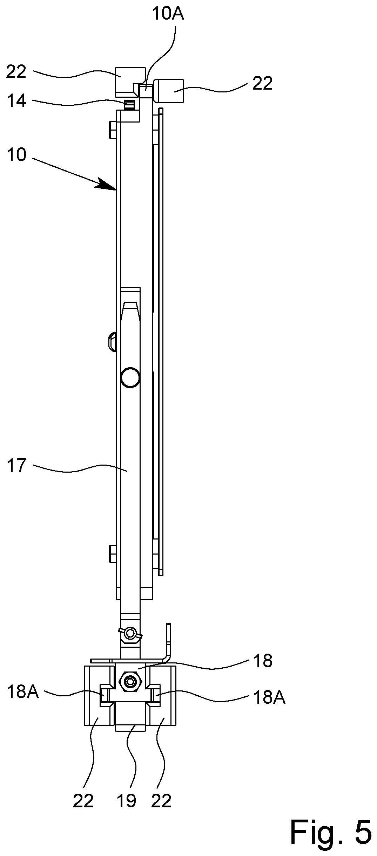

In Fig. 4 ist nur eine obere Schiene 22 gezeigt. Fig. 5 zeigt in einer anderen Seitenansicht in Richtung der Förderrichtung F, also quer zur Längserstreckung der Schienen 22, wie der Träger 10, insbesondere zusammen mit dem gekoppelten Wagen oder Gestell 17 an entgegengesetzten Seiten bzw. oben und unten von Schienen 22 beim Darstellungsbeispiel besonders bevorzugt geführt wird.

Vorzugsweise wird der Träger 10 bzw. das Gestell 17 oder insbesondere das Führungselement 18 seitlich und/oder vertikal - hier unten - von ein oder zwei Schienen 22 geführt, wie in Fig. 5 schematisch angedeutet. Beispielsweise können seitliche Rippen, Vorsprünge oder Stege 18A des Führungselements 18 in entsprechende Nuten insbesondere der auf entgegengesetzten Seiten angeordneten Führungsschienen 22 eingreifen. Besonders bevorzugt wird so eine Gleitführung realisiert. Jedoch sind auch andere konstruktive Lösungen möglich.

Auf der anderen Seite bzw. oben ist der Träger 10 bzw. ein nach oben vorspringender Trägerabschnitt 10A vorzugsweise nur seitlich durch ein oder zwei Schienen 22, wie in Fig. 5 angedeutet geführt. Auch hier wird vorzugsweise eine Gleitführung realisiert. Jedoch sind auch andere konstruktive Lösungen möglich.

Der Träger 10 ist insbesondere zusammen mit dem Gestell 17 oder umgekehrt in die Förderrichtung F oder entgegengesetzt dazu verschiebbar oder bewegbar.

Die Fördereinrichtung 20 bzw. der Förderantrieb 21 ermöglicht eine gewünschte Bewegung, Förderung und/oder Positionierung des Trägers 10 innerhalb der (jeweiligen) Beschichtungsvorrichtung 1 bzw. in der Anlage 100.

Beim Darstellungsbeispiel ist eine zumindest im Wesentlichen vertikale Ausrichtung des Trägers 10 bzw. der Linsen 2 (bezogen auf deren Haupterstreckungsebenen bzw. Flachseiten) bei der Förderung durch die Anlage 1 bzw. Beschichtungseinrichtung(en) 1 bevorzugt, um eine möglichst kompakte Bauform mit insbesondere geringer Grundfläche zu ermöglichen. Jedoch sind auch andere Ausrichtungen möglich.

In Fig. 4 sind schematisch die Sputterquellen 3 bzw. Targets 4 der Beschichtungsvorrichtung 1 in der Beschichtungskammer 7 angeordnet. Den Targets 4 sind Targetantriebe 23 zum Drehen der Targets 4 zugeordnet. Die Targetantriebe 23 sind vorzugsweise außerhalb der Beschichtungskammer 7 angeordnet, wie in Fig. 4 angedeutet. Jedoch sind auch andere konstruktive Lösungen möglich.

Die Drehachsen D bzw. Längserstreckungen L der Targets 4 verlaufen vorzugsweise vertikal.

Die Rotationsachsen A der Linsen 2 verlaufen vorzugsweise zumindest im Wesentlichen zumindest im Wesentlichen horizontal.

In Fig. 4 ist auch angedeutet, dass der Drehantrieb 11 der (jeweiligen) Beschichtungsvorrichtung 1 insbesondere mit einem entsprechenden Zahnrad vorzugsweise automatisch oder zwangsläufig mit dem Träger 10 bzw. der Drehkopplung 12 oder mindestens einem Ringelement 14 antriebsmäßig gekoppelt wird oder in Eingriff steht, wenn sich der Träger 10 in einer Beschichtungsposition in der Beschichtungsvorrichtung 1 befindet. Dementsprechend kann dann der Drehantrieb 11 die Linsen 2 beim Beschichten in die gewünschte Rotation um die Achsen A versetzen.

Zur Herstellung des genannten Antriebseingriffs steht insbesondere ein Zahnrad oder Ringelement 14 des Trägers 10 derart seitlich - hier nach oben - vor, so dass beim Einschieben oder Einführen des Trägers 10 zwangsweise die gewünschte Antriebskopplung erfolgt. Jedoch sind hier auch andere konstruktive Lösungen möglich.

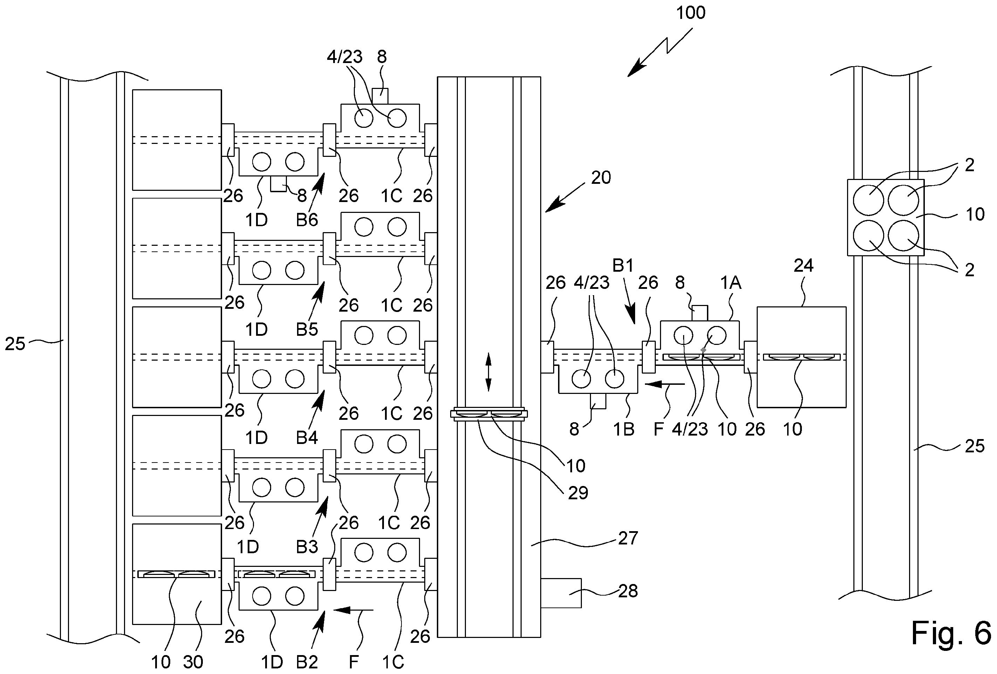

Nachfolgend wird anhand der schematischen Darstellung von Fig. 6 eine erste bevorzugte Ausführungsform der vorschlagsgemäßen Anlage 100 zur Beschichtung von Linsen 2 erläutert, wobei die bisherigen Ausführungen und Erläuterungen insbesondere entsprechend oder ergänzend, auch ohne explizite Wiederholung gelten.

Die Anlage 100 weist vorzugsweise eine Aufnahmestation 24 zur Aufnahme der zu beschichtenden Linsen 2 bzw. der Träger 10 mit zu beschichtenden Linsen 2 auf. Insbesondere dient die Aufnahmestation 24 einer Kopplung des Trägers 10 mit einem zugeordneten Wagen bzw. Gestell 17. Alternativ kann dies jedoch auch vorab oder getrennt erfolgen, sofern ein Wagen bzw. Gestell 17 überhaupt eingesetzt wird.

Die Aufnahmestation 24 kann beispielsweise manuell mit Trägern 10 und Linsen 2 beschickt werden. Alternativ kann auch eine automatische Aufnahme bzw. Beschickung mit Trägern 10 und/oder Linsen 2 erfolgen. Beispielsweise können die Träger 10 mit schon aufgenommenen Linsen 2 oder sonstige Behältnisse mit den Linsen 2 von einem optionalen Fördersystem 25, wie einem Förderband o. dgl., der Aufnahmestation 24 zugefördert und insbesondere automatisiert von der Aufnahmestation 24 aufgenommen werden.

Bedarfsweise können die Linsen 2 also auch in oder an der Aufnahmestation 24 manuell oder automatisiert in die Träger 10 aufgenommen oder eingesetzt werden.

Die Aufnahmestation 24 richtet den Träger 10 vorzugsweise in gewünschter Weise, hier insbesondere vertikal, aus, sofern erforderlich.

Es ist auch möglich, dass die Träger 10 mit oder ohne Linsen 2 bereits mit oder in der gewünschten Ausrichtung, hier insbesondere mit vertikaler Ausrichtung, der Aufnahmestation 24, insbesondere von dem Fördersystem 25, zugeführt bzw. zugefördert werden. Beispielsweise können die Träger 10 hierzu in einer Art Magazin oder Transportwagen und/oder geschichtet bzw. aufrecht der Aufnahmestation 24 zugefördert oder zugeleitet werden. So wird ein sehr kompakter Aufbau der Anlage 100 bei geringem Platzbedarf ermöglicht.

Vorzugsweise wird der Träger 10 zusammen mit den zu beschichtenden Linsen 2 ausschließlich in der bevorzugten Ausrichtung durch die Beschichtungsvorrichtung(en) 1 bzw. die gesamte Anlage 100 gefördert bzw. bewegt. Dies ist insbesondere einem einfachen Handling und/oder kompakten Aufbau zuträglich.

An die Aufnahmestation 24 schließt sich eine (erste) Beschichtungsvorrichtung 1 an, die zur leichteren Unterscheidung in Fig. 6 mit Fig. 1A bezeichnet ist und dem Aufbringen einer ersten Beschichtung dient.

Es folgt vorzugsweise eine weitere (erste) Beschichtungsvorrichtung 1B, die dem Aufbringen der ersten Beschichtung auf der entgegengesetzten Seite der Linsen 2 dient, so dass die Linsen 2 dann anschließend beidseitig beschichtet sind. Jedoch kann die Beschichtungsvorrichtung 1B auch dem Aufbringen einer sonstigen Beschichtung dienen.

Die beiden Beschichtungsvorrichtungen 1A, 1B bilden vorzugsweise eine (erste) Beschichtungslinie B, nachfolgend zur leichteren Unterscheidung als B1 bezeichnet.

In Fig. 6 ist angedeutet, dass die Targetantriebe 23 der ersten Beschichtungsvorrichtung 1A einerseits und der zweiten Beschichtungsvorrichtung 1B andererseits und damit auch die zugehörigen Targets 4 auf entgegengesetzten Seiten des Trägers 10 und damit der Linsen 2 angeordnet sind, um die gegenüberliegende bzw. beidseitige Beschichtung der Linsen 2 zu ermöglichen.

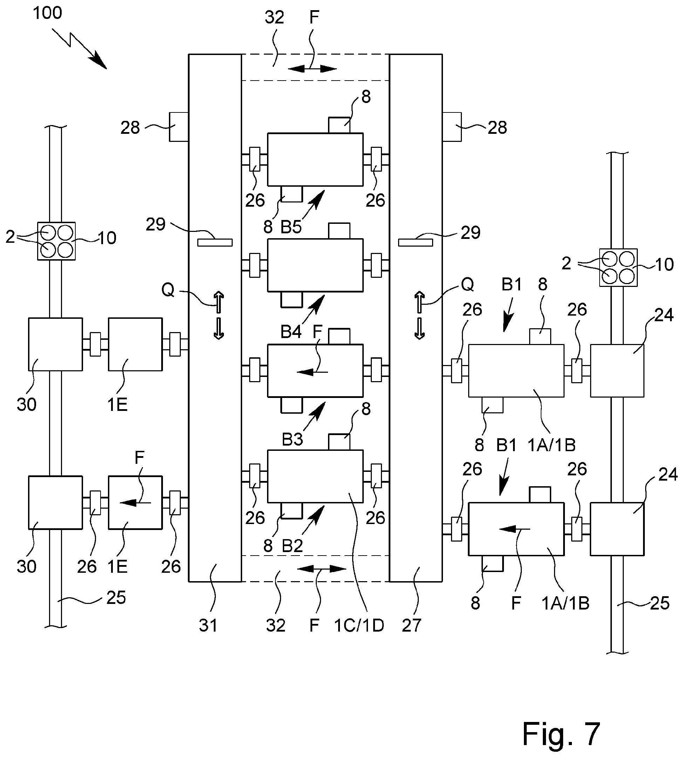

Es ist jedoch auch möglich, die beiden Beschichtungsvorrichtungen 1A und 1B in einem gemeinsamen Gehäuse und/oder mit einer gemeinsamen Beschichtungskammer 7 zu kombinieren (dies ist beispielhaft bei der in Fig. 7 dargestellten zweiten Ausführungsform angedeutet).

In Fig. 6 sind weiter schematisch Einrichtungen bzw. Vakuumpumpen 8 angedeutet, um die Beschichtungskammern 7 der Beschichtungsvorrichtungen 1 für das Beschichten zu evakuieren.

Vorzugsweise werden einige, mehrere oder alle Beschichtungsvorrichtungen 1 der Anlage 100 insbesondere geradlinig bzw. diskontinuierlich oder nacheinander von den Linsen 2 bzw. Trägern 10 durchfahren und/oder über eine Aufnahmeöffnung mit den Linsen 2 bzw. Trägern 10 beschickt, wobei die Linsen 2 bzw. Träger 10 über eine von der Aufnahmeöffnung getrennte Abgabeöffnung wieder abgegeben werden. Dies ist insbesondere einer gewünschten Verkettung der Beschichtungsvorrichtungen 1 bzw. Beschichtungskammern 7 und/oder einem aufeinanderfolgenden Durchfahren oder Durchlaufen der verschiedenen Beschichtungsvorrichtungen 1 bzw. Anlage 100 zuträglich.

Vorzugsweise ist jeder Beschichtungsvorrichtung 1 eine Schleuse 26 vor- und/oder nachgeordnet, um einerseits die Aufnahmeöffnung und andererseits die Abgabeöffnung für das Beschichten möglichst gasdicht verschließen zu können und insbesondere ein gewünschtes Vakuum - insbesondere ein Hochvakuum - für das Beschichten erzeugen zu können.

Optional kann die Aufnahmestation 24 auch bereits evakuiert oder unter ein Vorvakuum, insbesondere ein Grob- oder Feinvakuum, gesetzt werden, um beim Öffnen der Schleuse 26 zur ersten Beschichtungsvorrichtung 1A hin die Beschichtungsvorrichtung 1A nicht direkt auf Normaldruck zu belüften, sondern bereits auf einem möglichst oder relativ niedrigen Druck zu halten.

Der Träger 10 wird vorzugsweise gradlinig und/oder linear bzw. an oder von Schienen 22 geführt von der Aufgabestation 24 mittels der Fördereinrichtung 20, insbesondere entsprechender bzw. verteilter Förderantriebe 21, in die erste Beschichtungsvorrichtung 1A bzw. generell in oder durch die Beschichtungsvorrichtungen 1 und/oder durch die Anlage 100 gefördert bzw. bewegt.

Nach der Beschichtung in der ersten Beschichtungsvorrichtung 1A wird der Träger 10 zusammen mit den dann einseitig beschichteten Linsen 2 weiter, vorzugsweise wiederum gradlinig bzw. linear und/oder mittels entsprechender Schienen 22 bzw. mittels der Fördereinrichtung 20 bzw. der Förderantriebe 21 in die zweite Beschichtungsvorrichtung 1B gefördert, um dort die Linsen 2 auf der anderen Seite zu beschichten.

Die Beschichtungskammern 7 der Beschichtungsvorrichtungen 1A, 1B, also der verschiedenen Beschichtungsvorrichtungen 1 sind vorzugsweise getrennt oder separat ausgebildet und/oder voneinander trennbar, insbesondere gasdicht bzw. vakuumfest, hier durch die Schleuse(n) 26.

Die (erste) Beschichtungslinie B1 umfasst vorzugsweise zwei Beschichtungsvorrichtungen 1A, 1B zur entgegengesetzten Beschichtung. Jedoch ist auch möglich, dass die Beschichtungslinie B1 nur eine Beschichtungsvorrichtung 1, insbesondere zur wahlweisen Beschichtung von einer oder zwei Seiten, umfasst. Weiter umfasst die Beschichtungslinie B1 vorzugsweise auch entsprechende Schleusen 26, insbesondere am Anfang und am Ende und/oder zwischen einzelnen Beschichtungsvorrichtungen 1.

Besonders bevorzugt erfolgt eine Förderung derart, dass die zu beschichtenden Linsen 2 mit dem zugeordneten Träger 10 an einem Ende der Beschichtungslinie B1 aufgenommen und an einem anderen bzw. entgegengesetzten Ende wieder abgegeben werden. Alternativ ist es aber auch möglich, die Linsen 2 zur Beschichtung an einem Ende aufzunehmen und nach der Beschichtung am selben Ende der Beschichtungslinie B1 wieder abzugeben.

Vorzugsweise weist die Anlage 100 nicht nur eine (erste) Beschichtungsvorrichtung 1A oder erste Beschichtungsvorrichtungen 1A, 1B oder Beschichtungslinie B1, sondern darüber hinaus weitere Beschichtungsvorrichtungen 1 bzw. Beschichtungslinien B auf, denen - vorzugsweise wahlweise - die Linsen 2 insbesondere zusammen mit dem jeweiligen Träger 10 zuförderbar sind bzw. zugefördert werden.

Die ersten Beschichtungsvorrichtungen 1A und 1B sind besonders bevorzugt als Sputtervorrichtungen, insbesondere zum Magnetronsputtern, ganz besonders bevorzugt wie bezüglich Fig. 1 bis 3 beschrieben und/oder jeweils zum einseitigen Aufbringen einer Beschichtung ausgebildet.

Die beiden Vorrichtungen 1A und 1B sind vorzugsweise zum Aufbringen einer Beschichtung von entgegengesetzten Seiten auf die Linse(n) 2 und/oder mit - insbesondere bezüglich der Förderrichtung F und/oder Hauptebene des Trägers 10 bzw. der Linsen 2 - auf entgegengesetzten Seiten angeordneten Sputterquellen 3 bzw. Targets 4 versehen, wie in Fig. 6 schematisch angedeutet.

Die weiteren Beschichtungsvorrichtungen 1C und 1D sind vorzugsweise wie voranstehend beschrieben, also insbesondere entsprechend oder ähnlich der beiden Beschichtungsvorrichtungen 1A und 1B, und insbesondere eben auch zum Aufbringen von Beschichtungen auf entgegengesetzten Seiten ausgebildet.

Grundsätzlich können die beiden Beschichtungsvorrichtungen 1A und 1B einerseits und die beiden Beschichtungsvorrichtungen 1C und 1D andererseits auch unterschiedlich ausgebildet sein und/oder mit unterschiedlichen Beschichtungsverfahren arbeiten.

Die Anlage 100 bzw. Fördereinrichtung 20 weist vorzugsweise eine Transferkammer 27 auf, um die Linsen 2 bzw. den Träger 10 mit den Linsen 2 nach Aufbringen der ersten Beschichtung - insbesondere einer beidseitigen Grundbeschichtung - aufzunehmen und an die nachgeordneten weiteren Beschichtungsvorrichtungen 1C, 1D bzw. Beschichtungslinien B2 bis B6 - insbesondere unter Vakuum - weiterfördern zu können.

Insbesondere sind die weiteren Beschichtungsvorrichtungen 1 bzw. Beschichtungslinien B parallel an die Transferkammer 27 angeschlossen, können also unabhängig voneinander mit Linsen 2 bzw. den Trägern 10 beschickt werden.

Die Transferkammer 27 ist vorzugsweise mittels einer zugeordneten Vakuumpumpe 28 evakuierbar und/oder gestattet besonders bevorzugt ein Weiterfördern der Linsen 2 nach dem Beschichten in der Beschichtungsvorrichtung 1A und/oder 1B bzw. Beschichtungslinie B1 unter Vakuum bzw. Unterdruck an eine nachgeordnete bzw. anschließende Beschichtungsvorrichtung 1 bzw. Beschichtungslinie B, hier an eine der Beschichtungsvorrichtungen 1C oder Beschichtungslinien B2 bis B6.

Die Fördereinrichtung 20 bzw. Transferkammer 27 weist vorzugsweise einen Förderer 29 zur entsprechenden Handhabung bzw. Förderung, insbesondere Querförderung der Linsen 2 vorzugsweise zusammen mit dem zugehörigen Träger 10 auf. Insbesondere wird eine Förderung in eine Querrichtung Q, nämlich quer oder senkrecht zu der sonstigen primären, insbesondere linearen oder gradlinigen Förderrichtung F in der Anlage 100 ermöglicht oder realisiert.

Nach dem Aufbringen oder Fertigstellen der (ersten) Beschichtung bzw. der Grundbeschichtung in der ersten Beschichtungslinie B1 bzw. in der an die Transferkammer 27 angeschlossene Beschichtungsvorrichtung 1B wird die Schleuse 26 zur Transferkammer 27 geöffnet, und die Linsen 2 werden vorzugsweise zusammen mit dem Träger 10 in die Transferkammer 27 weitergefördert bzw. an diese übergeben.

Der Förderer 29 ermöglicht dann insbesondere eine Förderung bzw. Verschiebung oder Bewegung in die Querrichtung Q und/oder eine Weiterförderung, insbesondere wahlweise an eine der an die Transferkammer 27 angeschlossenen weiteren Beschichtungsvorrichtungen 1C bzw. Beschichtungslinien B2 bis B6.

Die weiteren Beschichtungsvorrichtungen 1C bzw. Beschichtungslinien B2 bis B6 sind vorzugsweise jeweils über eine Schleuse 26 und/oder parallel an die Transferkammer 27 angeschlossen, insbesondere so dass auch hier die Förderung der Linsen 2 bzw. Träger 10 in einer Förderrichtung F erfolgt, die vorzugsweise parallel oder in Verlängerung zu der Förderrichtung F zwischen der Aufnahmestation 24 und der Transferkammer 27 bzw. in der ersten Beschichtungslinie B1 verläuft. Jedoch sind auch andere konstruktive Lösungen möglich.

In der weiteren Beschichtungsvorrichtung 1C und einer sich vorzugsweise jeweils daran anschließenden Beschichtungsvorrichtung 1D werden eine weitere Beschichtung oder mehrere Beschichtungen auf die Linsen 2, vorzugsweise wieder abwechselnd von entgegengesetzten Seiten aufgebracht.

Die weiteren Beschichtungsvorrichtungen 1C und 1D gestatten insbesondere ein abwechselndes beidseitiges Beschichten der Linsen 2 und/oder sind vorzugsweise verkettet (gekoppelt) bzw. bilden eine (weitere) Beschichtungslinie B.

Die Beschichtungsvorrichtungen 1C und 1D und insbesondere auch eine sich daran anschließende Abgabestation 30 sind vorzugsweise wiederum derart angeordnet, dass eine zumindest im Wesentlichen gradlinige bzw. lineare Förderung der Träger 10 von der Transferkammer 27 durch die beiden Beschichtungsvorrichtungen 1C und 1D hindurch zu der sich anschließenden Abgabestation 30 ermöglicht wird. Jedoch sind auch andere konstruktive Lösungen oder Verläufe möglich.

Vor und nach und/oder zwischen den Beschichtungsvorrichtungen 1C und 1D sind jeweils vorzugsweise wiederum Schleusen 26 angeordnet.

Insbesondere weisen die weiteren Beschichtungslinien B2 bis B6 jeweils eine Beschichtungsvorrichtung 1C und eine sich anschließende Beschichtungsvorrichtung 1D auf bzw. sind davon gebildet.

Insbesondere sind Schleusen 26 zwischen den Bearbeitungslinien B2 bis B6 einerseits zu der Transferkammer 27 und andererseits jeweils zu der zugeordneten Abgabestation 30 angeordnet.

Nach dem Aufbringen der weiteren Beschichtung(en) - insbesondere von ein oder mehrlagigen Entspiegelungsschichten und/oder von ein oder mehr Verspiegelungsschichten - in den weiteren Beschichtungsvorrichtungen 1C, 1D bzw. in den weiteren bzw. zweiten Beschichtungslinien B2 bis B6 werden die Linsen 2 insbesondere zusammen mit den zugeordneten Trägern 10 an die jeweilige Abgabestation 30 weiter gefördert bzw. abgegeben.

In der Abgabestation 30 können die beschichteten Linsen 2 entweder manuell entnommen werden oder insbesondere automatisiert an das Fördersystem 25, wie ein Förderband o. dgl., abgegeben werden.

Es ist auch möglich, dass vor der Abgabe der Linsen 2 an die Abgabestation 30 ein weiteres oder abschließendes Beschichten oder Behandeln der Linsen 2, insbesondere zum so genannten Oberflächenfinish bzw. durch Aufbringen einer Endbeschichtung, erfolgt. Dies kann beispielsweise in den weiteren bzw. zweiten oder letzten Beschichtungslinien B2 bis B6 und/oder in einer oder mehreren zusätzlichen Beschichtungsvorrichtungen (siehe 1E bei der zweiten Ausführungsform gemäß Fig. 7) erfolgen.

Im Ergebnis können durch die Anlage 100 insbesondere fertig beschichtete Linsen bzw. Brillengläser 2 bereitgestellt bzw. hergestellt werden.

Die Abgabestation 30 ist vorzugsweise wiederum über eine Schleuse 26 an die weitere bzw. letzte Beschichtungsvorrichtung 1D bzw. Bearbeitungslinie B2 bis B6 bzw. das von der Anlage 100 vorzugsweise gebildete Vakuumsystem angeschlossen, also insbesondere vergleichbar zu dem Anschluss der Aufnahmestation 24. Vorzugsweise wird auch die Abgabestation 30 unter Unterdruck bzw. Vakuum gesetzt, um beim Öffnen der Schleuse 26 ein zumindest übermäßiges Belüften der Beschichtungsvorrichtung 1D bzw. Ansteigen des Gasdrucks in der Beschichtungsvorrichtung 1D zu verhindern.

Besonders bevorzugt wird von der Anlage 100 ein verkettetes oder verbundenes Vakuumsystem gebildet, das mehrere oder alle Beschichtungsvorrichtungen 1 bzw. Beschichtungskammern 7, ggf. die Schleusen 26, vorzugsweise mindestens eine Transferkammer 27 und optional die Aufnahmestation 24 und/oder Abgabestation 30 umfasst.

Vorzugsweise wird also ein durchgängiges Vakuumsystem gebildet, durch das die zu beschichtenden Linsen 2 bzw. Träger 10 mit den Linsen 2 gefördert werden.

Vorzugsweise wird die Anlage 100 bzw. deren Vakuumsystem im Betrieb generell auf oder unter einem Vakuum gehalten, auch wenn das Vakuum ggf. variiert. Beispielsweise werden die Beschichtungsvorrichtungen 1, zumindest die Beschichtungsvorrichtungen 1 zum Sputtern, zum Beschichten - also insbesondere bei geschlossenen Schleusen 26 - unter ein Hochvakuum gesetzt. Andere Teile der Anlage 100 bzw. des Vakuumsystems, wie die Transferkammer 27, die Aufnahmestation 24 und/oder die Abgabestation 30 und/oder sonstige Komponenten oder Verbindungen werden vorzugsweise auf ein geringeres Vakuum, also beispielsweise (nur) ein Grobvakuum oder Feinvakuum, gesetzt oder evakuiert.

Besonders bevorzugt wird während des fortlaufenden Betriebs und insbesondere auch beim Wechsel von Linsen 2 und/oder Trägern 10 zumindest in einigen, mehreren oder insbesondere allen Beschichtungsvorrichtungen 1 des Vakuumsystems ein bestimmtes Mindestvakuum, insbesondere ein Grobvakuum oder Feinvakuum, insbesondere also auch bei Öffnen der Schleusen 26, aufrechterhalten oder beibehalten. Dies ist insbesondere einem effizienten Beschichten bzw. Verfahrensablauf oder Betrieb zuträglich.

Vorzugsweise ist die Anlage 100 modular aufgebaut, so dass verschiedene Beschichtungsvorrichtungen 1, insbesondere auch mit verschiedenen, insbesondere unter Vakuum ablaufenden Beschichtungsverfahren in der Anlage 100 bzw. im Vakuumsystem kombiniert werden können.

Besonders bevorzugt erfolgt das Beschichten durch Gasphasenabscheidung, insbesondere chemische Gasphasenabscheidung (CVD oder Dampfphasenabscheidung genannt) und/oder physikalische Gasphasenabscheidung, also physikalische Beschichtungsverfahren, wie PVD, thermisches Verdampfen, Sputtern und/oder dergleichen.

Die vorschlagsgemäße Anlage 100 und das vorschlagsgemäße Verfahren gestatten insbesondere das Aufbringen einer Grundbeschichtung auf die Linsen 2 als erste Beschichtung hier mittels der Beschichtungsvorrichtung(en) 1A, 1B bzw. der ersten Beschichtungslinie B1. Das Aufbringen dieser Beschichtung dauert relativ kurz.

Später werden dann in den weiteren Beschichtungsvorrichtungen 1C, 1D bzw. weiteren/zweiten Beschichtungslinien B2 bis B6 vorzugsweise weitere Beschichtungen aufgebracht. Hierbei können die Linsen 2 ggf. auch mehrfach jeweils zwischen den beiden Beschichtungsvorrichtungen 1C und 1D wechseln und/oder unterschiedliche Gase und/oder Targets beim Beschichten eingesetzt werden. Dementsprechend dauert dieses zweite Beschichten, beispielsweise zum Aufbau eines Schichtpakets zur Entspiegelung bzw. zum Aufbringen von mehreren Antireflex-Schichten und/oder einer Verspiegelung, wesentlich länger als das Aufbringen der ersten Beschichtung bzw. Grundbeschichtung.

Im Hinblick auf einen guten Durchsatz der Anlage 100 sind daher vorzugsweise wesentlich mehr weitere bzw. zweite Beschichtungslinien B2 bis B6 als erste Beschichtungslinien B1 vorgesehen, insbesondere mehr als doppelt so viele.

Insbesondere kann die Anlage 100 bzw. die Fördereinrichtung 20 bzw. der Förderer 29 jeweils wahlweise - besonders bevorzugt in Abhängigkeit von der Verfügbarkeit, technischen Ausstattung und/oder den jeweiligen Anforderungen - die (weiter) zu beschichtenden Linsen 2 wahlweise einer der weiteren bzw. zweiten Beschichtungslinie B2 bis B6 zuführen bzw. zufördern.

Nachfolgend wird anhand von Fig. 7 eine zweite Ausführungsform der vorschlagsgemäßen Anlage 100 und des vorschlagsgemäßen Verfahrens näher erläutert, wobei insbesondere primär Unterschiede zu der ersten Ausführungsform hervorgehoben werden und insbesondere die bisherigen Ausführungen und Erläuterungen zu der ersten Ausführungsform und auch zum grundsätzlich bevorzugten Aufbau der Beschichtungsvorrichtung 1 entsprechend oder ergänzend gelten.

Bei der zweiten Ausführungsform können die Beschichtungsvorrichtungen 1A und 1B bzw. 1C und 1D, die jeweils eine Beschichtung der Linsen 2 von entgegengesetzten Seiten gestatten und/oder eine Beschichtungslinie B bilden, paarweise als eine Baueinheit ausgeführt und/oder mit einem gemeinsamen Gehäuse versehen sein.

Bei der zweiten Ausführungsform weist die Anlage 100 vorzugsweise zwei bzw. mehrere erste Bearbeitungslinien B1 auf, die vorzugsweise unabhängig voneinander mit zu beschichtenden Linsen 2 insbesondere über entsprechende separate Aufnahmestationen 24 mit zu beschichtenden Linsen 2 und zugehörigen Trägern 10 bestückbar oder beschickbar sind.

Die Beschichtungslinien B1 sind vorzugsweise parallel an die nachgeordnete Transferkammer 27 angeschlossen, insbesondere um die beschichteten Linsen 2 dann wahlweise an eine der zweiten oder weiteren Beschichtungslinien B2 bis B5 weiter zu fördern.

An die zweiten Beschichtungslinien B2 bis B5 schließt sich vorzugsweise eine zusätzliche Transferkammer 31 an, die vorzugsweise wie die Transferkammer 27 aufgebaut ist und/oder insbesondere einer wahlweisen Weiterförderung der beschichteten Linsen 2 an ein oder mehrere zusätzliche Vorrichtungen, insbesondere Beschichtungsvorrichtungen 1E, dient.

Vorzugsweise sind die Beschichtungslinien B2 bis B5 jeweils über Schleusen 26 an die vorgeordnete Transferkammer 27 und/oder die nachgeordnete Transferkammer 31 angeschlossen.

Generell ist anzumerken, dass die vorzugsweise alle Schleusen 26 individuell verschließbar sind, um einzelne Räume und insbesondere die Beschichtungskammern 7 der Beschichtungsvorrichtungen 1 bedarfsgerecht abtrennen und insbesondere unter Vakuum, vorzugsweise Hochvakuum, für das jeweilige Beschichten, das insbesondere durch sogenannte Gasphasenabscheidung, besonders bevorzugt durch Sputtern, erfolgt, zu setzen.

Die beiden Transferkammern 27, 31 sind optional durch eine oder zwei Förderverbindungen 32, wie in Fig. 7 gestrichelt angedeutet, verbunden, insbesondere um eine Rückförderung und/oder Kreisförderung und/oder ein Umgehen der zweiten Beschichtungslinien B2 bis B5 zu ermöglichen. Die Förderverbindungen 32 sind vorzugsweise ebenfalls wie die Transferkammern 27, 31 evakuierbar, insbesondere entsprechend gasdicht mit diesen verbunden und bilden einen Teil des vorschlagsgemäßen Vakuumsystems der Anlage 100.

Die optionalen Förderverbindungen 32 gestatten vorzugsweise eine zusätzliche Förderung parallel zu den normalen Förderungen F der Linsen 2, wahlweise auch in entgegengesetzter Richtung.

Die Förderverbindungen 32 sind vorzugsweise mit entsprechenden Förderern 29 (nicht dargestellt) ausgestattet.

Insbesondere ist es mittels mindestens einer Förderverbindung 32 möglich, dass Linsen 2 bzw. Träger 10 mit den Linsen 2 nach Durchlaufen einer der weiteren Beschichtungslinien B2 bis B5 über die Transferkammer 31 und die Förderverbindung 32 wieder an die Transferkammer 27 zurücktransportiert wird, um dann wahlweise wiederum die gleiche Beschichtungslinie B2 bis B5 oder eine andere Beschichtungslinie B2 bis B5 zu durchlaufen.

Alternativ oder zusätzlich können die Linsen 2 bzw. Träger 10 grundsätzlich auch in einer oder jeder Beschichtungslinie B, besonders bevorzugt in den weiteren Beschichtungslinien B2 bis B5, bedarfsweise zwischen den einzelnen Beschichtungsvorrichtungen, hier insbesondere 1C und 1D, vorzugsweise direkt wechseln bzw. vor- und zurückbewegt werden, um insbesondere einen optimalen Ablauf beim Aufbringen von mehreren Schichten zu ermöglichen.

Es ist anzumerken, dass das zweite Beschichten in den zweiten bzw. weiteren Beschichtungslinien B2 bis B5 oftmals mit dem Aufbringen von etwa zehn oder mehr Schichten einhergeht, so dass dieses Beschichten oftmals mehr als doppelt oder dreimal so lange dauert, wie das Aufbringen der ersten Beschichtung bzw. Grundbeschichtung. Dementsprechend sind dann vorzugsweise auch entsprechend mehr zweite Beschichtungslinien B2 bis B5 als erste Beschichtungslinien B1 vorgesehen.

Die Fördereinrichtung 20 bzw. Transferkammer 27 ist optional auch zur Zwischenspeicherung von Linsen 2 bzw. Trägern 10 mit Linsen 2 nach Aufbringen der ersten Beschichtung bzw. Grundbeschichtung bzw. nach Verlassen der ersten Beschichtungslinie B1 ausgebildet. Hierzu kann insbesondere die Transferkammer 27 oder deren Förderer 29 entsprechend ausgebildet sein, beispielsweise zur Aufnahme von mehreren Linsen 2 oder Trägern 10, durch Bereitstellung von zusätzlichen Förderorganen und/oder durch Bereitstellung von Lagerplätzen, Lagerbereichen und/oder Magazinen, die dann vorzugsweise ebenfalls in das Vakuumsystem integriert sind.

Zu der genannten Zwischenspeicherung kann alternativ oder ergänzend auch die zusätzliche Transferkammer 31 über eine Förderverbindung 32 und/oder besonders bevorzugt die bereits erwähnte Ring- oder Kreisförderung von Linsen 2 bzw. Trägern 10 mit Linsen 2 durch die zusätzlichen Förderverbindungen 32 in Kombination mit den Transferkammern 27 und 31 oder ähnliche Konfigurationen eingesetzt werden.

Die Anlage 100 weist vorzugsweise ein oder mehrere zusätzliche Beschichtungsvorrichtungen 1E zur weiteren bzw. nachgeordneten Oberflächenbehandlung bzw. - beschichtung der Linsen 2 auf.

Insbesondere sind zwei oder mehr zusätzliche Beschichtungsvorrichtungen 1E parallel an die zusätzliche Transferkammer 31, wie in Fig. 7 angedeutet, oder alternativ an die Transferkammer 27 angeschlossen, besonders bevorzugt jeweils wiederum über Schleusen 26. So wird durch die zusätzlichen Beschichtungsvorrichtungen 1E eine zusätzliche Oberflächenbehandlung und/oder Beschichtung der Linsen 2 ermöglicht, insbesondere das bereits angesprochene Oberflächenfinish und/oder Aufbringen einer Schutzschicht.

Die Transferkammer 31 kann optional wiederum zu einer Zwischenspeicherung von Linsen 2 bzw. Trägern 10 mit Linsen 2 vor Weiterleitung an die ein oder mehreren zusätzlichen Beschichtungsvorrichtungen 1E eingesetzt werden. Alternativ oder zusätzlich kann eine entsprechende Zwischenspeicherung auch durch die bereits erwähnte Kreis- oder Ringförderung bei Kopplung der beiden Transferkammern 27 und 31 über zwei Förderverbindungen 32 erfolgen.

Generell ist anzumerken, dass die Zwischenspeicherung auch bereits über eine Kopplung der beiden Transferkammern 27 und 31 über eine einzige Förderverbindung 32 erreicht oder verbessert werden kann, insbesondere wenn die Förderverbindung 32 ein beliebiges Wechseln der Linsen 2 bzw. Träger 10 von der Transferkammer 27 in die Transferkammer 31 und umgekehrt ermöglicht.

Schließlich werden die fertig beschichteten bzw. behandelten Linsen 2 - hier vorzugsweise direkt von den zusätzlichen Vorrichtungen 1E - insbesondere jeweils an eine eigene Abgabestation 30 abgegeben.

Bei der zweiten Ausführungsform ist schematisch angedeutet, dass das Fördersystem 25 bzw. ein Förderband o. dgl. auch durch die Aufnahmestationen 24 und/oder Abgabestationen 30 geführt sein kann.

Es ist generell anzumerken, dass die Beschichtungsvorrichtungen 1 grundsätzlich zumindest im Wesentlichen baugleich, ggf. aber auch unterschiedlich aufgebaut und/oder bestückt sein können. Beispielsweise können insbesondere auch unterschiedlich aufgebaute oder unterschiedlich arbeitende Beschichtungsvorrichtungen 1 für unterschiedliche Beschichtungslinien B eingesetzt werden.

Besonders bevorzugt erfolgt das Beschichten der Linsen 2 in den Beschichtungsvorrichtungen 1A bis 1D bzw. Beschichtungslinien B durch Sputtern, insbesondere Magnetronsputtern, wie bereits insbesondere anhand der Fig. 1 bis 3 beispielhaft für eine Beschichtungsvorrichtung 1 erläutert. Die Beschichtungsvorrichtungen 1A bis 1D der Anlage 100 sind insbesondere in dieser bevorzugten Weise aufgebaut. Jedoch können auch anders aufgebaute Beschichtungsvorrichtungen eingesetzt und/oder kombiniert werden.

Die zusätzlichen Beschichtungsvorrichtungen 1E beschichten die Linsen 2 vorzugsweise nicht durch Sputtern bzw. Kathodenzerstäubung, sondern insbesondere durch thermisches Verdampfen, CVD, PVD oder dergleichen.

Optional können die zusätzlichen Beschichtungsvorrichtungen 1E auch in die weiteren Beschichtungslinien B2 bis B5 und/oder in eine der weiteren Beschichtungsvorrichtungen 1C, 1D integriert sein. In diesem Fall kann bedarfsweise die zusätzliche Transferkammer 31 entfallen, auch wenn diese im Hinblick auf eine mögliche Minimierung der ansonsten erforderlichen Anzahl von Abgabestationen 30 sinnvoll ist oder trotzdem eingesetzt wird.

Besonders bevorzugt betrifft die vorliegende Erfindung, die vorschlagsgemäße Anlage 100 und das vorschlagsgemäße Verfahren das Beschichten von Linsen 2 im Vakuum, vorzugsweise durch Gasphasenabscheidung, insbesondere Sputtern, besonders bevorzugt Magnetronsputtern. Vorzugsweise werden zumindest einige Schichten, insbesondere die erste Beschichtung und/oder die zweite Beschichtung, durch Gasphasenabscheidung, insbesondere Sputtern, besonders bevorzugt Magnetronsputtern, auf die Linsen 2 mit der vorschlagsgemäßen Anlage 100 bzw. dem vorschlagsgemäßen Verfahren aufgebracht.

Die Linsen bzw. Brillengläser 2 weisen - vorzugsweise gekrümmte oder gewölbte, insbesondere konkave oder konvexe - Oberflächen bzw. Flachseiten auf, die beschichtet werden. Die vorliegende Erfindung bzw. die vorschlagsgemäße Anlage 100 und die vorschlagsgemäßen Verfahren beziehen sich insbesondere nur auf das Beschichten solcher gekrümmter bzw. gewölbter Oberflächen von Linsen bzw. Brillengläsern 2. Hier kommt es insbesondere auf höchste Genauigkeit und besonders gleichmäßige Ausbildung der jeweiligen Schichten an.

Besonders bevorzugt wird beginnend mit der Aufnahmestation 24 bis zur Abgabe der dann beschichteten Linse 2 an der Abgabestation 30 durchgängig die Linse 2 in einen Vakuum bzw. Vakuumsystem gehalten, auch wenn das Vakuum - insbesondere während des Betriebs, durch Öffnen und Schließen der Schleusen 26 und/oder räumlich in Abhängigkeit vom jeweiligen Bereich der Anlage 100 - variieren kann, beispielsweise in den Beschichtungsvorrichtungen 1 und/oder Schleusen 26 bzw. Transferkammern 27, 31 und/oder zusätzlichen Vorrichtungen 1E auch unterschiedlich sein kann und/oder lokal unterschiedliche Gase zugesetzt oder eingesetzt werden können.

Beim oder zum Beschichten werden einzelne oder mehrere Beschichtungsvorrichtungen 1, insbesondere zumindest die Beschichtungsvorrichtungen 1A und 1B bzw. die erste Beschichtungslinie B1 und/oder die Beschichtungsvorrichtungen 1C und 1D bzw. zweiten Beschichtungslinien B2 bis B5 bzw. deren Beschichtungskammer(n) 7 vorzugsweise auf einen Druck von unter 0,1 Pa evakuiert bzw. dort ein Hochvakuum angelegt oder erzeugt. Gleiches gilt vorzugsweise auch für die zusätzlichen Beschichtungsvorrichtungen 1E. Je nach Anforderung können diese gegebenenfalls aber auch bei einem etwas höheren Druck bzw. in einem "geringeren" Vakuum, also z. B. in einem Feinvakuum, arbeiten.

Der Druck in der restlichen Anlage 100 bzw. in der Transferkammer 27 und/oder 31 und/oder in der zusätzlichen Förderverbindung 32 und/oder in der Aufnahmestation 24 und/oder Abgabestation 30 ist vorzugsweise etwas höher als in den Beschichtungsvorrichtungen 1 und/oder liegt insbesondere unter 1.000 Pa und/oder über 0,1 Pa. Insbesondere wird dort also auch ein Vakuum angelegt oder erzeugt, insbesondere ein Grobvakuum oder Feinvakuum.

Die vorschlagsgemäße Anlage 100 und das vorschlagsgemäße Verfahren sowie der vorschlagsgemäße Träger 10 gestatten insbesondere eine individuelle oder angepasste Beschichtung von Kleingruppen von Linsen 2, insbesondere von jeweils zwei oder vier Linsen 2, wobei ein guter hoher Durchsatz durch die wahlweise Verteilung auf verschiedene Beschichtungslinien B bzw. Beschichtungsvorrichtungen 1 ermöglicht wird.

Insbesondere werden die Linsen 2 in einem Batch-Betrieb, also nicht in einem Durchlaufverfahren bzw. nicht kontinuierlich, beschichtet, wobei das Beschichten insbesondere nur in kleinen Gruppen von Linsen 2, vorzugsweise in Gruppen von einzelnen Paaren oder mehreren Paaren von Linsen 2, bedarfsweise aber auch von einzelnen Linsen oder beliebigen Anzahlen von Linsen 2, besonders bevorzugt von weniger als zehn Linsen 2, erfolgt.

Die vorschlagsgemäße Anlage 100 bzw. das vorschlagsgemäße Verfahren wird vorzugsweise zum Aufbringen einer oder mehrerer Antireflexschichten verwendet.

Vorschlagsgemäß erfolgt insbesondere auch ein reaktives Beschichten, wobei durch entsprechende Zuführung von Reaktiv-Gas, beispielsweise von Stickstoff, Wasserstoff und/oder Sauerstoff, zum Arbeits-Gas (Edelgas), insbesondere Argon, das Targetmaterial damit reagieren und eine gewünschte Beschichtung auf der Linse 2 bilden kann.

Die Fördereinrichtung 20 der Anlage 100 umfasst vorzugsweise die dezentralen bzw. verteilten Förderantriebe 21, Transferkammer(n) 27, 31 und/oder Förderer 29.

Die Förderantriebe 21 sind insbesondere in oder an den Beschichtungsvorrichtungen 1, Beschichtungskammern 7, Beschichtungslinien B, Schleusen 26, Transferkammern 27, 31, Förderern 29, Aufnahmestationen 24 und/oder Abgabestationen 30 angeordnet, um die gewünschte Förderung der Träger 10 zu ermöglichen.

Generell ist anzumerken, dass die zweite Beschichtung bzw. Antireflexbeschichtung vorzugsweise aus einer Einzelschicht oder aus einem mehrschichtigen Stapel aus dielektrischen Materialien aufgebaut oder zusammengesetzt wird. Insbesondere sind mehrschichtige Beschichtungen, umfassend Schichten mit hohem Brechungsindex und Schichten mit niedrigem Brechungsindex vorgesehen. Die Materialien der einzelnen Schichten des Schichtstapels sind in der Regel keramische Materialien, die mindestens im sichtbaren Spektralbereich transparent sind. Insbesondere werden hierzu verschiedene Oxide oder Mischoxide eingesetzt. Die Dicke dieser Schichten beträgt im Allgemeinen zwischen 10 und 100 nm. Die Gesamtdicke eines Antireflektionsschichtstapels beträgt in der Regel zwischen 100 und 1.000 nm.

Das bevorzugte Vakuumsystem bzw. die bevorzugte Verkettung aller für die Brillenglasbeschichtung notwendigen Prozessschritte in einer Anlage bzw. einem Vakuumsystem führt insbesondere dazu, dass keine Einzelschritte oder Zwischenschritte in der Atmosphäre erfolgen. Hierdurch wird ein besonders effizienter Ablauf ermöglicht, wobei insbesondere aber auch unerwünschte Verschmutzungen oder dergleichen vermieden werden können.

Einzelne Aspekte und Merkmale der verschiedenen Ausführungsformen und Varianten können auch beliebig miteinander kombiniert, aber auch unabhängig voneinander realisiert werden.

Weitere, mit den vorgenannten Aspekten kombinierbare Aspekte der Erfindung sind:
1. Anlage (100) zur Beschichtung von Brillengläsern (2),
   mit mehreren Beschichtungsvorrichtungen (1) zur Beschichtung der Brillengläser (2) im Vakuum, vorzugsweise mittels Gasphasenabscheidung, insbesondere Sputtern, und
   mit einer Fördereinrichtung (20) zur Förderung der Brillengläser (2) oder eines Trägers (10) mit den Brillengläsern (2) von einer Beschichtungsvorrichtung (1) zu einer anderen Beschichtungsvorrichtung (1),
   **dadurch gekennzeichnet,**
   dass die Anlage (100) eine Transferkammer (27, 31) aufweist und dass die Beschichtungsvorrichtungen (1) separate Beschichtungskammern (7) aufweisen, wobei die Beschichtungskammern (7) und die Transferkammer (27, 31) ein durchgehendes bzw. zusammenhängendes Vakuumsystem bilden.
2. Anlage nach Aspekt 1, dadurch gekennzeichnet, dass die Beschichtungskammern (7) mittels Schleusen (26) voneinander und/oder gegenüber der Transferkammer (27, 31) getrennt oder trennbar sind.
3. Anlage nach Aspekt 1 oder 2, dadurch gekennzeichnet, dass die Anlage (100) bzw. Fördereinrichtung (20) zur diskontinuierlichen und/oder linearen Förderung der Brillengläser (2) von einer Beschichtungsvorrichtung (1) in eine andere Beschichtungsvorrichtung (1) ausgebildet ist.
4. Anlage nach einem der Aspekte 1 bis 4, dadurch gekennzeichnet, dass jede Beschichtungsvorrichtung (1) einen eigenen Förderantrieb (21) zur Weiterförderung der Brillengläser (2) an eine andere Beschichtungsvorrichtung (1) oder die Transferkammer (27, 31) aufweist.
5. Anlage (100) zur Beschichtung von Brillengläsern (2), insbesondere nach einem der voranstehenden Aspekte,
   mit einem Träger (10) zur Halterung der zu beschichtenden Brillengläser (2),
   mit mehreren Beschichtungsvorrichtungen (1) zur Beschichtung der Brillengläser (2) im Vakuum, vorzugsweise mittels Gasphasenabscheidung, insbesondere Sputtern, und
   mit einer Fördereinrichtung (20) zur Förderung des Trägers (10) von einer Beschichtungsvorrichtung (1) zu einer anderen Beschichtungsvorrichtung (1),
   **dadurch gekennzeichnet,**
   dass die Beschichtungsvorrichtungen (1) separate Beschichtungskammern (7) aufweisen und/oder mittels Schleusen (26) voneinander getrennt oder trennbar sind.
6. Anlage nach Aspekt 5, dadurch gekennzeichnet, dass die Anlage (100) bzw. Fördereinrichtung (20) eine Transferkammer (27, 31) insbesondere mit einer zugeordneten Vakuumpumpe (28) aufweist, wobei der Träger (10) aus einer Beschichtungsvorrichtung (1) durch die Transferkammer (27, 31) in eine andere Beschichtungsvorrichtung (1) förderbar ist.
7. Anlage nach Aspekt 5 oder 6, dadurch gekennzeichnet, dass jede Beschichtungsvorrichtung (1) einen eigenen Förderantrieb (21) zur insbesondere linearen Förderung, Aufnahme und/oder Weiterförderung des Trägers (10) aufweist.
8. Anlage nach einem der voranstehenden Aspekte, dadurch gekennzeichnet, dass der Träger (10) mit den Brillengläsern (2) zur Beschichtung in die jeweilige Beschichtungsvorrichtung (1) aufnehmbar ist.
9. Anlage nach einem der voranstehenden Aspekte, dadurch gekennzeichnet, dass der Träger (10) zur rotierbaren Halterung der Brillengläser (2) um eigene Achsen (A) ausgebildet ist.
10. Vorrichtung nach einem der voranstehenden Aspekte, dadurch gekennzeichnet, dass der Träger (10) die Brillengläser (2) mit stationärem Schwerpunkt bzw. zentrisch rotierbar hält.
11. Anlage nach einem der voranstehenden Aspekte, dadurch gekennzeichnet, dass die Anlage (100) und/oder der Träger (10) zur beidseitigen Beschichtung von Brillengläsern (2) ausgebildet ist bzw. sind.
12. Anlage nach einem der voranstehenden Aspekte, dadurch gekennzeichnet, dass die Anlage (100) bzw. Fördereinrichtung (20) zur diskontinuierlichen und/oder linearen Förderung des Trägers (10) aus einer Beschichtungsvorrichtung (1) in eine andere Beschichtungsvorrichtung (1) ausgebildet ist.
13. Anlage nach einem der voranstehenden Aspekte, dadurch gekennzeichnet, dass die Anlage (100) oder Fördereinrichtung (20) einen Wagen oder ein Gestell (17) zur Aufnahme und Halterung des Trägers (10) und/oder zur Förderung des Trägers (10) von oder zu einer Beschichtungsvorrichtung (1) aufweist.
14. Anlage nach einem der voranstehenden Aspekte, dadurch gekennzeichnet, dass die Anlage (100) bzw. Fördereinrichtung (20) den Träger (10) gegebenenfalls zusammen mit einem Gestell (17) an entgegengesetzten Seiten und/oder mittels Schienen (22) verschiebbar führt.
15. Anlage nach einem der voranstehenden Aspekte, dadurch gekennzeichnet, dass der Träger (10) mit derselben, insbesondere vertikalen Ausrichtung durch mehrere oder alle Beschichtungsvorrichtungen (1) förderbar ist.
16. Anlage nach einem der voranstehenden Aspekte, dadurch gekennzeichnet, dass mehrere oder alle Beschichtungsvorrichtungen (1) jeweils einen eigenen Drehantrieb (11) zur Rotation von zu beschichtenden Brillengläsern (2) aufweisen.
17. Vorrichtung nach einem der voranstehenden Aspekte, dadurch gekennzeichnet, dass die Anlage (100) derart ausgebildet ist, dass der Träger (10) beim Einsetzen oder Einschieben in die Beschichtungsvorrichtung (1) bzw. deren Beschichtungskammer (7) automatisch antriebsmäßig oder getriebemäßig mit einem Drehantrieb (11) der Beschichtungsvorrichtung (1) koppelbar ist oder gekoppelt wird.
18. Anlage nach einem der voranstehenden Aspekte, dadurch gekennzeichnet, dass die Anlage (100) unterschiedlich arbeitende Beschichtungsvorrichtungen (1) für unterschiedliche Beschichtungsverfahren und/oder mindestens eine Vorrichtung (33) zum Oberflächenfinish aufweist.
19. Anlage nach einem der voranstehenden Aspekte, dadurch gekennzeichnet, dass die Fördereinrichtung (20) oder Transferkammer (27, 31) zur Weiterförderung der Brillengläser (2) wahlweise an verschiedene Beschichtungsvorrichtungen (1) oder Beschichtungslinien (B) ausgebildet ist.
20. Anlage nach einem der voranstehenden Aspekte, dadurch gekennzeichnet, dass die Anlage (100) zur Beschichtung der Brillengläser (2) jeweils in Gruppen, insbesondere von eins bis zehn Brillengläsern (2), ausgebildet ist.
21. Anlage nach Aspekt 20, dadurch gekennzeichnet, dass die Gruppen nacheinander in verschiedenen Beschichtungsvorrichtungen (1) beschichtet werden.
22. Anlage nach einem der voranstehenden Aspekte, dadurch gekennzeichnet, dass die Anlage (100) zur Aufnahme mehrerer Gruppen von Brillengläsern (2) bzw. Träger (10) mit jeweils einer Kleingruppe von Brillengläsern (2) ausgebildet ist.
23. Anlage nach einem der voranstehenden Aspekte, dadurch gekennzeichnet, dass die Anlage (100) derart ausgebildet ist, dass die Brillengläser (2) individuell spezifisch bzw. in Abhängigkeit von einer konvexen oder konkaven Krümmung ihrer zu beschichtenden Oberfläche(n) und/oder in Abhängigkeit von der Krümmung der zu beschichtenden Oberfläche(n) unterschiedlich beschichtet werden und/oder unterschiedlichen Beschichtungsvorrichtungen (1) zugefördert werden und/oder die Beschichtungsvorrichtungen (1) bzw. Beschichtungsparameter entsprechend angepasst werden.
24. Anlage nach einem der voranstehenden Aspekte, dadurch gekennzeichnet, dass der Anlage (100) ein Fördersystem (25) zugeordnet ist oder einen Teil der Anlage (100) bildet, um die Anlage (100) bzw. deren Vakuumsystem automatisiert mit zu beschichtenden Brillengläsern (2) und/oder Trägern (10) mit zu beschichtenden Brillengläsern (2) zu beschicken und/oder um beschichtete Brillengläser (2) bzw. Träger (10) mit beschichteten Brillengläsern (2) automatisiert weg zu fördern, insbesondere an eine andere Bearbeitungseinrichtung weiter zu fördern.
25. Verfahren zur Beschichtung von Brillengläsern (2) in einer Anlage (100) im Vakuum, vorzugsweise mittels Gasphasenabscheidung, insbesondere Sputtern,
   wobei die Brillengläser (2) zunächst mit einer ersten Beschichtung oder Grundbeschichtung in einer Beschichtungsvorrichtung (1A, 1B) oder Beschichtungslinie (B1) und anschließend mit mindestens einer weiteren Beschichtung, wie ein oder mehreren Antireflex-Schichten oder einer Verspiegelung, in einer anderen Beschichtungsvorrichtung (1C, 1D) oder Beschichtungslinie (B2-B6) versehen werden,
   **dadurch gekennzeichnet,**
   dass die Brillengläser (2) von der Beschichtungsvorrichtung (1A, 1B) bzw. Beschichtungslinie (B1) zur ersten Beschichtung bzw. Grundbeschichtung anschließend durch eine Transferkammer (27, 31) unter Vakuum zu der anderen Beschichtungsvorrichtung (1C, 1D) bzw. Beschichtungslinie (B2-B6) gefördert werden, und/oder
   dass die Brillengläser (2) in Gruppen von bis zu zehn Brillengläsern (2), insbesondere zwei oder vier Brillengläsern (2) in der jeweiligen Beschichtungsvorrichtung (1) beschichtet werden.
26. Verfahren nach Aspekt 20, dadurch gekennzeichnet, dass die andere Beschichtungsvorrichtung (1C, 1D) bzw. Beschichtungslinie (B2-B6) aus einer Mehrzahl von Beschichtungsvorrichtungen (1C, 1D) bzw. Beschichtungslinien (B2-B6) insbesondere in Abhängigkeit von der Verfügbarkeit und/oder technischen Ausstattung ausgewählt wird.
27. Verfahren zur Beschichtung von Brillengläsern (2) im Vakuum, vorzugsweise mittels Gasphasenabscheidung, insbesondere Sputtern, besonders bevorzugt nach Aspekt 25 oder 26,
   wobei ein Träger (10) mehrere zu beschichtende Brillengläser (2) hält,
   **dadurch gekennzeichnet,**
   dass der Träger (10) nacheinander verschiedenen Beschichtungsvorrichtungen (1) zugeführt wird und dort die Brillengläser (2) beschichtet werden, wobei die Beschichtungsvorrichtungen (1) beim Beschichten mittels Schleusen (26) voneinander getrennt werden und/oder wobei die Brillengläser (2) während des Beschichtens um eigene Achsen (A) rotiert werden, und/oder
   dass der Träger (10) mit einer Zahnstange (19) oder mit einem Wagen oder Gestell (17) zur Förderung in bzw. durch mindestens eine Beschichtungsvorrichtung (1) gekoppelt wird.
28. Verfahren nach Aspekt 27, dadurch gekennzeichnet, dass der Träger (10) von einer Beschichtungsvorrichtung (1) zumindest im Wesentlichen linear oder gradlinig in eine andere Beschichtungsvorrichtung (1) bewegt wird.
29. Verfahren nach Aspekt 27 oder 28, dadurch gekennzeichnet, dass der Träger (10) mit den zu beschichtenden Brillengläsern (2) von einer Beschichtungsvorrichtung (1) durch eine evakuierte Transferkammer (27, 31) in eine andere Beschichtungsvorrichtung (1) gefördert wird.
30. Verfahren nach einem der Aspekte 27 bis 29, dadurch gekennzeichnet, dass der Träger (10) beim Einführen oder Einschieben in die Beschichtungsvorrichtung (1) automatisch antriebsmäßig gekoppelt wird, so dass die Brillengläser (2) beim Beschichten rotiert werden können.
31. Verfahren nach einem der Aspekte 27 bis 31, dadurch gekennzeichnet, dass die Beschichtungsvorrichtungen (1) jeweils mittels eines eigenen Förderantriebs (21) den Träger (10) in die jeweilige Beschichtungsvorrichtung (1) hinein und/oder aus dieser heraus fördern.
32. Verfahren nach einem der Aspekte 25 bis 31, dadurch gekennzeichnet, dass die Brillengläser (2) nacheinander in verschiedenen Beschichtungsvorrichtungen (1) von entgegengesetzten Seiten beschichtet werden.
33. Verfahren nach einem der Aspekte 25 bis 32, dadurch gekennzeichnet, dass die Brillengläser (2) mit unterschiedlichen Beschichtungsverfahren beschichtet werden.
34. Verfahren nach einem der Aspekte 25 bis 33, dadurch gekennzeichnet, dass die Brillengläser (2) abschließend einem Oberflächenfinish unterzogen bzw. mit einer Endbeschichtung versehen werden, insbesondere zur Erzeugung einer oleophoben, hydrophoben und/oder nicht beschlagenden Oberfläche.
35. Verfahren nach einem der Aspekte 25 bis 34, dadurch gekennzeichnet, dass die Gruppen von Brillengläsern (2) nacheinander in verschiedenen Beschichtungsvorrichtungen (1) beschichtet werden.
36. Verfahren nach einem der Aspekte 25 bis 35, dadurch gekennzeichnet, dass die Anlage mehrere Gruppen bzw. Träger (10) mit jeweils einer Kleingruppe von Brillengläsern (2) aufnimmt.
37. Verfahren nach einem der Aspekte 25 bis 36, dadurch gekennzeichnet, , dass die Brillengläser (2) individuell bzw. in Abhängigkeit von einer konvexen oder konkaven Krümmung ihrer zu beschichtenden Oberfläche (n) und/oder in Abhängigkeit von der Krümmung der zu beschichtenden Oberfläche (n) unterschiedlichen beschichtet werden und/oder unterschiedlich Beschichtungsvorrichtungen (1) zugefördert werden.
38. Verfahren nach einem der Aspekte 25 bis 37, dadurch gekennzeichnet, dass die Anlage (100) bzw. deren Vakuumsystem automatisiert mit zu beschichtenden Brillengläsern (2) und/oder Trägern (10) mit zu beschichtenden Brillengläsern (2) beschickt wird und/oder dass beschichtete Brillengläser (2) bzw. Träger (10) mit beschichteten Brillengläsern (2) automatisiert weg gefördert werden, insbesondere an eine andere Bearbeitungseinrichtung.
39. Verfahren nach einem der Aspekte 25 bis 38, dadurch gekennzeichnet, dass die Brillengläser (2) nach Aufnahme in die Anlage (100) bzw. deren Vakuumsystem ausschließlich unter Vakuum gehalten werden, bis mehrere, insbesondere alle Beschichtungen und/oder ein Oberflächenfinish aufgebracht worden ist.
40. Verfahren nach einem der Aspekte 25 bis 39, dadurch gekennzeichnet, dass jeweils zwei nebeneinander bzw. parallel angeordnete Sputterquellen (3) oder Targets (4) für das Aufbringen der ersten Beschichtung und einer weiteren Beschichtung eingesetzt werden.
41. Verfahren nach einem der Aspekte 25 bis 40, dadurch gekennzeichnet, dass jeweils zwei Sputterquellen (3) oder Targets (4) für das Beschichten einer Seite und der anderen Seite der Brillengläser (2) eingesetzt werden.
42. Träger (10) zur Beschichtung von Brillengläsern (2) mittels Gasphasenabscheidung, insbesondere Sputtern,
   **dadurch gekennzeichnet,**
   dass der Träger (10) zur rotierbaren Halterung von mehreren Brillengläsern (2) um eigene Achsen (A) ausgebildet ist, wobei die Brillengläser (2) von entgegengesetzten Seiten zur beidseitigen Beschichtung zugänglich sind und/oder wobei die Brillengläser (2) oder deren Zentren zumindest im wesentlichen in einer Ebene liegen und/oder wobei der Träger (10) zur umfangsseitigen und/oder federnden Halterung der Brillengläser (2) ausgebildet ist.
43. Träger nach Aspekt 42, dadurch gekennzeichnet, dass der Träger (10) eine an einem Rand frei zugängliche Drehkopplung (12), insbesondere in Form eines vorstehenden Zahnrads oder Ringelements (14), aufweist.
44. Träger nach Aspekt 42 oder 43, dadurch gekennzeichnet, dass der Träger (10) Ringelemente (14) zur rotierbaren Halterung der Brillengläser (2) aufweist.

### Bezugszeichenliste:

- 1: Beschichtungsvorrichtung
- 2: Brillenglas / Linse
- 3: Sputterquelle
- 4: Target
- 5: Magnetanordnung
- 6: Spannungsquelle
- 7: Beschichtungskammer
- 8: Einrichtung / Vakuumpumpe
- 9: Gaszuführung
- 10: Träger
- 10A: Trägerabschnitt
- 11: Drehantrieb
- 12: Drehkopplung
- 13: Halteelement
- 14: Ringelement
- 15: Grundkörper
- 16: Öffnung
- 17: Gestell
- 18: Führungselement
- 18A: Steg
- 19: Zahnstange
- 20: Fördereinrichtung
- 21: Förderantrieb
- 22: Schiene
- 23: Targetantrieb
- 24: Aufnahmestation
- 25: Fördersystem
- 26: Schleuse
- 27: Transferkammer
- 28: Vakuumpumpe
- 29: Förderer
- 30: Abgabestation
- 31: zusätzliche Transferkammer
- 32: Förderverbindung

- 100: Anlage

- A: Rotationsachse der Linse
- B: Beschichtungslinie
- D: Drehachse des Targets
- F: Förderrichtung
- H: Hauptrichtung
- L: Längserstreckung des Targets
- M: Mittelebene
- Q: Querrichtung
- S: Sputterwolke
- V: Abstand Linsenachse-Targetachse
- W: Winkel
- Z: Abstand Linse-Target

## Patentansprüche

1. Anlage (100) zur Beschichtung von Brillengläsern (2),
mit einem Träger (10) zur Halterung der zu beschichtenden Brillengläser (2),
mit mehreren Beschichtungsvorrichtungen (1) zur Beschichtung der Brillengläser (2) im Vakuum, vorzugsweise mittels Gasphasenabscheidung, insbesondere Sputtern, und
mit einer Fördereinrichtung (20) zur Förderung des Trägers (10) von einer Beschichtungsvorrichtung (1) zu einer anderen Beschichtungsvorrichtung (1),
wobei die Beschichtungsvorrichtungen (1) separate Beschichtungskammern (7) aufweisen und/oder mittels Schleusen (26) voneinander getrennt oder trennbar sind,
**dadurch gekennzeichnet,**
**dass** jede Beschichtungsvorrichtung (1) einen eigenen Förderantrieb (21) zur Förderung, Aufnahme und/oder Weiterförderung des Trägers (10) aufweist, und/oder dass der Träger (10) zur rotierbaren Halterung der Brillengläser (2) um eigene Achsen (A) ausgebildet ist.

2. Anlage nach Anspruch 1, **dadurch gekennzeichnet, dass** der Träger (10) die Brillengläser (2) mit stationärem Schwerpunkt bzw. zentrisch rotierbar hält.

3. Anlage nach einem der voranstehenden Ansprüche, **dadurch gekennzeichnet,**
**dass** die Anlage (100) oder Fördereinrichtung (20) einen Wagen oder ein Gestell (17) zur Aufnahme und Halterung des Trägers (10) und/oder zur Förderung des Trägers (10) von oder zu einer Beschichtungsvorrichtung (1) aufweist, und/oder
**dass** die Anlage (100) bzw. Fördereinrichtung (20) den Träger (10) gegebenenfalls zusammen mit einem Gestell (17) an entgegengesetzten Seiten und/oder mittels Schienen (22) verschiebbar führt, und/oder
**dass** der Träger (10) mit derselben, insbesondere vertikalen Ausrichtung durch mehrere oder alle Beschichtungsvorrichtungen (1) förderbar ist.

4. Anlage nach einem der voranstehenden Ansprüche, **dadurch gekennzeichnet, dass** mehrere oder alle Beschichtungsvorrichtungen (1) jeweils einen eigenen Drehantrieb (11) zur Rotation von zu beschichtenden Brillengläsern (2) aufweisen.

5. Anlage nach einem der voranstehenden Ansprüche, **dadurch gekennzeichnet, dass** die Anlage (100) derart ausgebildet ist, dass der Träger (10) beim Einsetzen oder Einschieben in die Beschichtungsvorrichtung (1) bzw. deren Beschichtungskammer (7) automatisch antriebsmäßig oder getriebemäßig mit einem Drehantrieb (11) der Beschichtungsvorrichtung (1) koppelbar ist oder gekoppelt wird.

6. Anlage nach einem der voranstehenden Ansprüche, **dadurch gekennzeichnet, dass** die Fördereinrichtung (20) zur Weiterförderung der Brillengläser (2) wahlweise an verschiedene Beschichtungsvorrichtungen (1) oder Beschichtungslinien (B) ausgebildet ist.

7. Anlage nach einem der voranstehenden Ansprüche, **dadurch gekennzeichnet, dass** die Anlage (100) derart ausgebildet ist, dass die Brillengläser (2) individuell spezifisch bzw. in Abhängigkeit von einer konvexen oder konkaven Krümmung ihrer zu beschichtenden Oberfläche(n) und/oder in Abhängigkeit von der Krümmung der zu beschichtenden Oberfläche(n) unterschiedlich beschichtet werden und/oder unterschiedlichen Beschichtungsvorrichtungen (1) zugefördert werden und/oder die Beschichtungsvorrichtungen (1) bzw. Beschichtungsparameter entsprechend angepasst werden.

8. Anlage nach einem der voranstehenden Ansprüche, **dadurch gekennzeichnet, dass** der Anlage (100) ein Fördersystem (25) zugeordnet ist oder einen Teil der Anlage (100) bildet, um die Anlage (100) bzw. deren Vakuumsystem automatisiert mit zu beschichtenden Brillengläsern (2) und/oder Trägern (10) mit zu beschichtenden Brillengläsern (2) zu beschicken und/oder um beschichtete Brillengläser (2) bzw. Träger (10) mit beschichteten Brillengläsern (2) automatisiert weg zu fördern, insbesondere an eine andere Bearbeitungseinrichtung weiter zu fördern.

9. Verfahren zur Beschichtung von Brillengläsern (2) im Vakuum, vorzugsweise mittels Gasphasenabscheidung, insbesondere Sputtern,
wobei ein Träger (10) mehrere zu beschichtende Brillengläser (2) hält,
wobei der Träger (10) nacheinander verschiedenen Beschichtungsvorrichtungen (1) zugeführt wird und dort die Brillengläser (2) beschichtet werden,
**dadurch gekennzeichnet,**
**dass** die Beschichtungsvorrichtungen (1) beim Beschichten mittels Schleusen (26) voneinander getrennt werden, wobei die Beschichtungsvorrichtungen (1) jeweils mittels eines eigenen Förderantriebs (21) den Träger (10) in die jeweilige Beschichtungsvorrichtung (1) hinein und/oder aus dieser heraus fördern, und/oder
**dass** die Brillengläser (2) während des Beschichtens um eigene Achsen (A) rotiert werden.

10. Verfahren nach Anspruch 9, **dadurch gekennzeichnet, dass** der Träger (10) mit einer Zahnstange (19) oder mit einem Wagen oder Gestell (17) zur Förderung in bzw. durch mindestens eine Beschichtungsvorrichtung (1) gekoppelt wird.

11. Verfahren nach Anspruch 9 oder 10, **dadurch gekennzeichnet, dass** der Träger (10) beim Einführen oder Einschieben in die Beschichtungsvorrichtung (1) automatisch antriebsmäßig gekoppelt wird, so dass die Brillengläser (2) beim Beschichten rotiert werden können.

12. Verfahren nach einem der Ansprüche 9 bis 11, **dadurch gekennzeichnet, dass** die Brillengläser (2) individuell bzw. in Abhängigkeit von einer konvexen oder konkaven Krümmung ihrer zu beschichtenden Oberfläche (n) und/oder in Abhängigkeit von der Krümmung der zu beschichtenden Oberfläche (n) unterschiedlichen beschichtet werden und/oder unterschiedlich Beschichtungsvorrichtungen (1) zugefördert werden.

13. Verfahren nach einem der Ansprüche 9 bis 12, **dadurch gekennzeichnet, dass** die Anlage (100) bzw. deren Vakuumsystem automatisiert mit zu beschichtenden Brillengläsern (2) und/oder Trägern (10) mit zu beschichtenden Brillengläsern (2) beschickt wird und/oder dass beschichtete Brillengläser (2) bzw. Träger (10) mit beschichteten Brillengläsern (2) automatisiert weg gefördert werden, insbesondere an eine andere Bearbeitungseinrichtung.

14. Träger (10) zur Beschichtung von Brillengläsern (2) mittels Gasphasenabscheidung, insbesondere Sputtern,
**dadurch gekennzeichnet,**
**dass** der Träger (10) zur rotierbaren Halterung von mehreren Brillengläsern (2) um eigene Achsen (A) ausgebildet ist, wobei die Brillengläser (2) von entgegengesetzten Seiten zur beidseitigen Beschichtung zugänglich sind und/oder wobei die Brillengläser (2) oder deren Zentren zumindest im Wesentlichen in einer Ebene liegen und/oder wobei der Träger (10) zur umfangsseitigen und/oder federnden Halterung der Brillengläser (2) ausgebildet ist.

15. Träger nach Anspruch 14, **dadurch gekennzeichnet, dass** der Träger (10) eine an einem Rand frei zugängliche Drehkopplung (12), insbesondere in Form eines vorstehenden Zahnrads oder Ringelements (14), und/oder Ringelemente (14) zur rotierbaren Halterung der Brillengläser (2) aufweist.
